(19) Europäisches Patentamt
European Patent Office
Office européen des brevets

(11) **EP 3 311 495 B1**

(12) **FASCICULE DE BREVET EUROPEEN**

(45) Date de publication et mention
de la délivrance du brevet:
**24.02.2021 Bulletin 2021/08**

(21) Numéro de dépôt: **16729939.5**

(22) Date de dépôt: **20.06.2016**

(51) Int Cl.:
**H03M 13/27** *(2006.01)*

(86) Numéro de dépôt international:
**PCT/EP2016/064164**

(87) Numéro de publication internationale:
**WO 2016/203039 (22.12.2016 Gazette 2016/51)**

(54) **CONCEPTION DE L'ENTRELACEUR POUR DES CODES TURBO EN FONCTION DU MOTIF DE POINÇONNAGE**

INTERLEAVER DESIGN FÜR TURBO KODES IN ABHÄNGIGKEIT DES PUNKTIERUNGSMUSTERS

INTERLEAVER DESIGN FOR TURBO CODES IN DEPENDENCE ON THE PUNCTURING PATTERN

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.06.2015 FR 1555670**

(43) Date de publication de la demande:
**25.04.2018 Bulletin 2018/17**

(73) Titulaires:
• **ORANGE**
**75015 Paris (FR)**
• **Institut Mines-Telecom**
**29238 Brest Cedex 3 (FR)**

(72) Inventeurs:
• **GARZON BOHORQUEZ, Ronald Edicson**
**29200 Brest (FR)**
• **ABDEL NOUR, Charbel**
**29200 Brest (FR)**
• **DOUILLARD, Catherine**
**29100 Brest (FR)**

(74) Mandataire: **Vidon Brevets & Stratégie**
**16B, rue de Jouanet**
**BP 90333**
**35703 Rennes Cedex 7 (FR)**

(56) Documents cités:
**US-A1- 2002 007 475      US-A1- 2007 288 834**

• **HYUN-KYUNG KIM ET AL: "Interleaver design for punctured turbo codes based on RSC code structure", PROC. 2013 INTERNATIONAL CONFERENCE ON ICT CONVERGENCE (ICTC), IEEE, 14 octobre 2013 (2013-10-14), pages 393-397, XP032527058, DOI: 10.1109/ICTC.2013.6675380**
• **CHATZIGEORGIOU I ET AL: "Punctured binary turbo-codes with optimized performance", PROC. 62ND IEEE VEHICULAR TECHNOLOGY CONFERENCE 2005 (VTC-2005-FALL), DALLAS, TX, USA 25-28 SEPT., 2005, PISCATAWAY, NJ, USA,IEEE, vol. 3, 25 septembre 2005 (2005-09-25), pages 1965-1969, XP010878817, DOI: 10.1109/VETECF.2005.1558451 ISBN: 978-0-7803-9152-9**
• **BERROU C ET AL: "Designing good permutations for turbo codes: towards a single model", PROC. 2004 IEEE INTERNATIONAL CONFERENCE ON COMMUNICATIONS (ICC 2004), 20 - 24 JUNE 2004, PARIS, IEEE OPERATIONS CENTER, PISCATAWAY, NJ, USA, vol. 1, 20 juin 2004 (2004-06-20), pages 341-345, XP010710014, DOI: 10.1109/ICC.2004.1312507 ISBN: 978-0-7803-8533-7 cité dans la demande**
• **MOTOROLA: "Contention-Free Interleaver Designs for LTE Turbo Codes", INTERNET CITATION, 19 janvier 2007 (2007-01-19), XP002473951, Extrait de l'Internet: URL:http://www.3gpp.org/ftp/tsg_ran/WG1_RL 1/TSGR1_47bis/Docs/ [extrait le 2008-03-26]**

- A. PEROTTI ET AL: "A New Upper Bound on the Minimum Distance of Turbo Codes", IEEE TRANSACTIONS ON INFORMATION THEORY, vol. 50, no. 12, 1 décembre 2004 (2004-12-01), pages 2985-2997, XP055260197, USA ISSN: 0018-9448, DOI: 10.1109/TIT.2004.838358
- JINHONG YUAN ET AL: "Combined Turbo Codes and Interleaver Design", IEEE TRANSACTIONS ON COMMUNICATIONS, IEEE SERVICE CENTER, PISCATAWAY, NJ. USA, vol. 47, no. 4, 1 avril 1999 (1999-04-01), XP011009398, ISSN: 0090-6778
- RONALD GARZON BOHORQUEZ ET AL: "On the Equivalence of Interleavers for Turbo Codes", IEEE WIRELESS COMMUNICATIONS LETTERS, vol. 4, no. 1, 1 février 2015 (2015-02-01), pages 58-61, XP55258757, Piscataway, NJ, USA ISSN: 2162-2337, DOI: 10.1109/LWC.2014.2367517 cité dans la demande

**Description**

**Domaine technique**

La présente invention concerne les procédés et produits programmes d'ordinateur pour le codage d'un message numérique d'entrée mettant en œuvre un turbo-encodeur, notamment du type à poinçonnage.

En particulier, l'invention concerne l'entrelacement mis en œuvre par le turbo-encodeur.

**Arrière-plan**

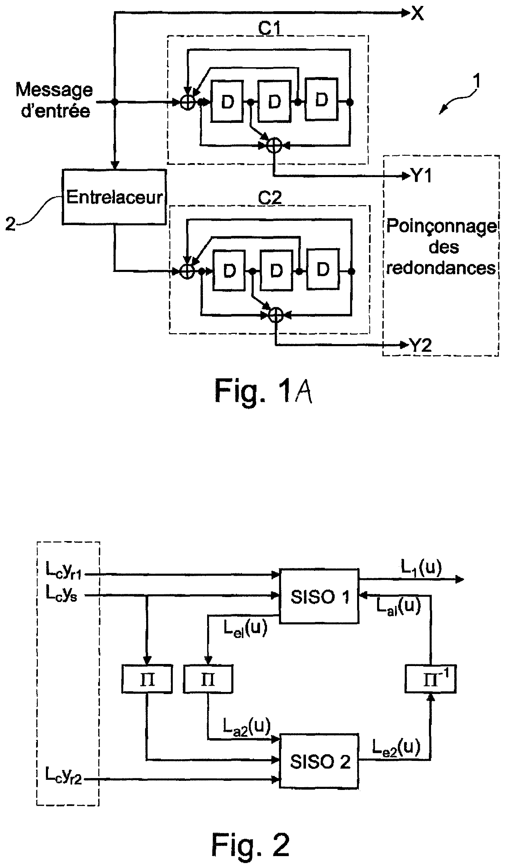

Les turbocodes sont des codes correcteurs d'erreurs dont les performances approchent la limite de Shannon, comme décrit dans le livre de C. Berrou (ed.), Codes et turbocodes, "Chapitre 7 : Turbocodes convolutifs", Collection IRIS, Springer, 2007. La structure conventionnelle d'un turbo-encodeur 1, représentée à la figure 1A, comprend la concaténation parallèle de deux codes convolutifs systématiques récursifs C1 et C2 (CSR) séparés par un entrelaceur 2. Le message numérique d'entrée de longueur $K$ est encodé dans son ordre d'arrivée, dit ordre naturel, par l'encodeur C1, et dans l'ordre entrelacé, ou permuté, par l'encodeur C2.

En réception, comme représenté à la figure 2, le décodage de ce code fait appel à deux décodeurs à entrées et sorties pondérées ou SISO (« *Soft-In Soft-Out* » en anglais). A partir des informations relatives aux symboles d'information $L_c y_s$, et aux symboles de redondance $L_c y_{r1}$ et $L_c y_{r2}$, disponibles en sortie du canal, chaque décodeur calcule une information dite extrinsèque $L_{e1}$ et $L_{e2}$ sur les symboles d'information décodés, qu'il échange avec l'autre décodeur suivant un processus itératif. Les décodeurs convergent ainsi vers une décision commune $L_1$.

Le rendement de codage global $R$ du turbocode de la figure 1A est égal à 1/3 (avant poinçonnage). Pour augmenter le rendement de codage d'un turbocode, la technique la plus utilisée consiste à poinçonner les symboles transmis suivant un motif périodique. Avec cette technique, le même codeur et le même décodeur peuvent être utilisés pour tous les rendements de codage. D'autre part, il est admis qu'il est préférable de poinçonner les symboles de redondance Y1 et Y2 plutôt que les symboles d'information, comme expliqué dans les articles de O. Acikel et W. Ryan, "Punctured turbo-codes for BPSK/QPSK channels" IEEE Trans. Commun., vol. 47, no. 9, pp. 1315-1323, Sept. 1999, et de F. Mo et al., "Analysis of puncturing pattern for high rate turbo codes", Proc. IEEE Conférence on Military Communications (MIL-COM 1999), vol. 1, Sep. 1999, pp. 547-550. En effet, en réception, les symboles d'information sont utilisés pour le décodage des deux codes élémentaires C1 et C2, tandis que chaque redondance n'est utilisée que pour le décodage d'un seul des codes. L'absence d'un symbole d'information est par conséquent *a priori* plus pénalisant que l'absence d'un symbole de redondance.

Le poinçonnage des symboles d'information est décrit dans la demande US 2008/0256424.

Comme démontré dans les articles de S. Crozier et al., "On designing turbo-codes with data puncturing", Canadian Workshop of Information Theory (CWIT 2005), Juin 2005, "Rate-compatible turbo codes designed with puncture-constrained DRP interleavers", IEEE Global Telecommun. Conf., Dec 2011, pp. 1-5, et "On the error-rate performance of 4-state turbo codes with puncture-constrained DRP interleavers", IEEE International Conférence on Communications (ICC), Juin 2012, pp. 2601-2605, le poinçonnage de symboles d'information judicieusement choisis peut permettre d'augmenter la distance minimale de Hamming du turbocode et par conséquent d'améliorer ses performances à faibles taux d'erreurs, sans pour autant dégrader ses performances à forts et moyens taux d'erreurs. Néanmoins, il n'existe, à la connaissance de la Demanderesse, aucune méthode concernant la manière de choisir le motif de poinçonnage, en particulier le nombre et les positions des symboles d'information poinçonnés.

Lorsque des symboles d'information sont poinçonnés, tous les motifs de poinçonnage ne sont pas admissibles. Les motifs de poinçonnage conduisant à des distances minimales de Hamming du code élémentaire égales à 0 ou à 1, dits catastrophiques, doivent être éliminés. En effet, dans de telles conditions, le code élémentaire perd son pouvoir de correction et, même à des niveaux de bruit très faibles, le décodeur prend de mauvaises décisions et conduit à un taux d'erreurs élevé.

En outre, le niveau de fiabilité de l'information extrinsèque calculée sur un symbole d'information en sortie d'un décodeur élémentaire dépend entre autres de la position du symbole considéré dans la période de poinçonnage, du poinçonnage ou non de la ou des redondances associées, et du nombre de redondances poinçonnées associées au symbole d'information, le cas échéant. En effet, dans le cas où une seule redondance est calculée par le code élémentaire pour chaque symbole d'information, c'est-à-dire dans le cas d'un rendement $R_c$ du code élémentaire non poinçonné égal à 1/2 dans le cas d'un code binaire, lorsque la redondance est poinçonnée, l'information extrinsèque calculée sur le symbole d'information correspondant est moins fiable que lorsque la redondance n'est pas poinçonnée. De même, dans le cas où plusieurs redondances sont calculées par le code élémentaire pour chaque symbole d'information, c'est-à-dire pour un rendement du code élémentaire $R_c$ non poinçonné inférieur à 1/2 dans le cas d'un code binaire, plus le nombre de redondances poinçonnées est élevé, moins l'information extrinsèque calculée sur le symbole d'information correspondant est fiable.

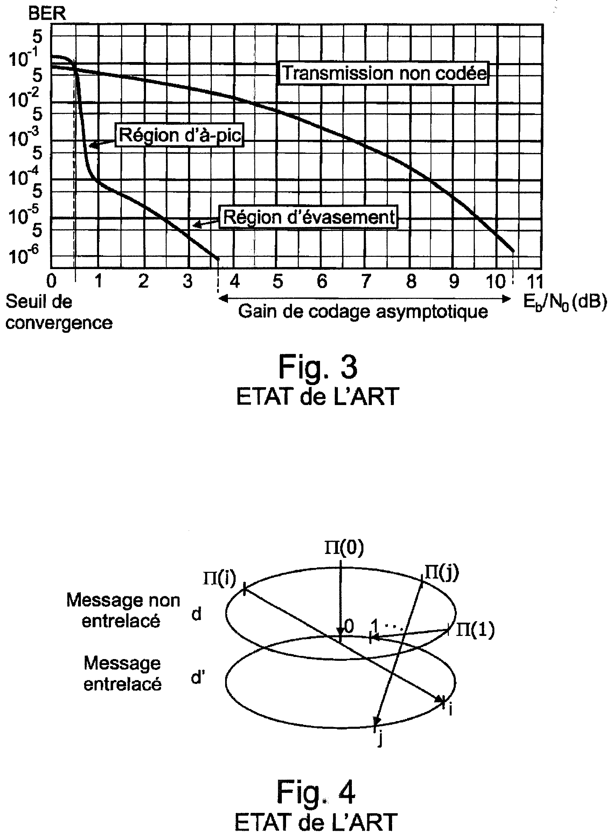

L'allure de la courbe connue de taux d'erreurs en sortie d'un turbo-décodeur est représentée à la figure 3. Dans la partie haute de la courbe, à forts et moyens taux d'erreurs, dite région d'à-pic (« *waterfall* » en anglais), on observe une région de forte décroissance du taux d'erreurs en fonction du rapport signal-à-bruit. Puis, au-dessus d'une certaine valeur du rapport signal-à-bruit, la pente de la courbe diminue, indiquant que le gain asymptotique du turbocode est atteint, dans une région dite d'évasement (« *error floor* » ou « *error flare* » en anglais). Le gain asymptotique du turbocode est fixé par son spectre des distances, qui énumère le nombre de mots du code à la distance minimale de Hamming et aux distances supérieures. Le nombre de mots du code à la distance d est appelé multiplicité associée à *d*.

Les performances d'un turbocode, notamment aux faibles taux d'erreurs, dans la région dite d'évasement, sont très dépendantes de la fonction d'entrelacement.

L'entrelaceur d'un turbo-encodeur permet de lutter efficacement contre l'occurrence de paquets d'erreurs en réception, à l'entrée au moins d'un des deux décodeurs correspondant aux codes C1 et C2, jouant par ce biais un rôle sur les performances du turbocode dans la région d'à-pic. L'entrelaceur a également un impact sur la distance de Hamming minimale du turbocode, qui gouverne son comportement à faibles taux d'erreurs dans la région d'évasement.

Le premier objectif de dispersion des paquets d'erreurs est facilement obtenu à l'aide d'un entrelaceur régulier, comme décrit dans le livre de C. Berrou susmentionné, par exemple un entrelaceur ligne-colonne. Cependant, ce livre montre que ce type d'entrelaceur ne permet pas d'obtenir des distances minimales de Hamming élevées car il produit des motifs d'erreurs rectangulaires de poids faibles. Un entrelaceur efficace permet de casser la régularité des motifs d'erreurs rectangulaires en introduisant un certain degré de désordre ou d'irrégularité.

Des méthodes d'entrelacement de turbocodes sont connues des demandes WO 2000/035103, WO 2000/010257, WO 2006/069392, US 2007/0288834, WO 2007/047472, WO 2008/057041, et WO 2010/148763

La demande US2007/028834 et les articles de Kim Hyung-Kyung, "Interleaver Design for punctured turbo codes based on RSC code structure", Proc. 2013 International Conférence on ICT Convergence, pp. 393-397, et de I. Chatzigeorgiou, "Punctured binary turbo codes with optimized performance", Proc. 62nd Vehicular Technology Conférence, pp. 1965-1969, qui révèlent une relation entre la conception de l'entrelaceur et le motif de poinçonnage, sont particulièrement intéressants.

Plusieurs familles d'entrelaceurs irréguliers sont connues, notamment les entrelaceurs dits ARP (« *Almost Regular Permutation* » en anglais), décrits dans l'article de C. Berrou et al., "Designing good permutations for turbocodes: towards a single model," IEEE International Conférence on Communications, vol. 1, 2004, pp. 341-345, ou DRP (« *Dithered Relative Prime* » en anglais), décrits dans l'article de S. Crozier et P. Guinand, "High-performance low-memory interleaver banks for turbo-codes," IEEE 54th Vehicular Technology Conference, vol. 4, Oct. 2001, pp. 2394-2398, ou QPP *(« Quadratic Permutation Polynomial* » en anglais), décrits dans l'article de J. Sun et O. Takeshita, "Interleavers for turbo codes using permutation polynomials over integer rings," IEEE Trans. Inf. Theory, vol. 51, no. 1, pp. 101-119, Jan. 2005.

Les entrelaceurs ARP et DRP sont basés sur un entrelacement global circulaire régulier, dans laquelle on insère un certain degré de désordre par le biais d'une permutation locale.

L'entrelaceur ARP, décrit notamment dans la demande US 2008/0086674, est fondé sur le modèle mathéma-tique suivant :

$$\Pi(i) = (Pi + S(i \bmod Q)) \bmod K,$$

où *i* = 0...*K* - 1 représente l'adresse du symbole d'information après entrelacement et $\Pi(i)$ l'adresse du même symbole avant entrelacement, comme représenté à la figure 4, dans le cas de codes élémentaires circulaires. Les paramètres de cet entrelaceur sont *P* la période de l'entrelaceur régulier, *Q,* un diviseur de *K,* représentant le degré de désordre inséré par le biais du vecteur *S,* correspondant au vecteur d'ajustement insérant les irrégularités dans l'entrelaceur régulier par le biais de *Q* valeurs entières.

L'entrelaceur régulier s'exprime par : $\Pi(i) = Pi \bmod K,$ avec *i* = 0...*K* - 1.

L'entrelaceur DRP, considéré comme un sous-ensemble des entrelaceurs ARP, comme expliqué dans l'article de Garzón Bohórquez et al. "On the equivalence of interleavers for turbo codes," IEEE Wireless Communication Letters, vol. 4, no 1, pp. 58-61, février 2015, applique une permutation locale sur des groupes de *W* bits avant que ne soit effectué l'entrelacement régulier global, puis une nouvelle permutation sur des groupes de *R* bits avant la lecture définitive.

L'entrelaceur QPP, considéré comme un cas particulier de l'entrelaceur ARP, comme expliqué dans l'article susmentionné de Garzón Bohórquez et al., est basé sur une permutation polynomiale quadratique :

$$\Pi(i) = (f_1 i + f_2 i^2) \bmod K,$$

où *i* = 0...*K* - 1 représente l'adresse du symbole d'information après entrelacement et $\Pi(i)$ l'adresse du même symbole d'information avant entrelacement.

L'entrelaceur ARP a été adopté dans les standards DVB-RCS/RCS2, DVB-RCT et WiMAX (IEEE 802.16), tandis que l'entrelaceur QPP est utilisé dans les standards de communications mobiles LTE et LTE-Advanced.

Quelle que soit la famille d'entrelaceur adoptée, il est nécessaire de trouver les paramètres qui confèrent à l'entrelaceur de bonnes propriétés de distance et donc une région d'évasement aussi basse que possible. De manière idéale, les codes élémentaires du turbocode étant fixés, les valeurs de ces paramètres doivent être calculées pour chaque taille $K$ de bloc du message à coder, et pour chaque valeur de rendement de codage.

Néanmoins, le processus de recherche de ces paramètres s'avère en pratique lourd et consommateur de puissance de calcul, car pour chaque jeu de paramètres considéré, il est nécessaire, soit de simuler le comportement du turbocode à faibles taux d'erreurs afin de détecter la position de la région d'évasement, soit d'estimer son spectre des distances à l'aide de méthodes telles que celles décrites dans les articles de C. Berrou et al., "Computing the minimum distance of linear codes by the error impulse method," IEEE Global Telecommun. Conf., vol. 2, Nov 2002, pp. 1017-1020, ou de R. Garello et A. Vila-Casado, "The all-zero iterative decoding algorithm for turbo code minimum distance computation," IEEE International Conférence on Communications (ICC), vol. 1, Juin 2004, pp. 361-364, ou les articles de S. Crozier et al. "Estimating the minimum distance of turbo-codes using double and triple impulse methods", IEEE Commun. Lett., vol. 9, no. 7, pp. 631-633, 2005, ou "Estimating the minimum distance of large-block turbo codes using iterative multiple-impulse methods," 4th Int. Symposium on Turbo Codes and Related Topics (ISTC), 2006, pp. 1-6, ou "Estimating the minimum distance oflarge block turbo codes using the event impulse method" Int. Symposium on Turbo Codes and Iterative Information Processing (ISTC), Sept. 2010, pp. 439-443.

Ainsi, en pratique, dans les standards utilisant les entrelaceurs ARP et QPP, pour chaque taille de bloc $K$, les paramètres d'entrelacement ne dépendent pas du rendement de codage et les turbocodes obtenus ne présentent pas de bonnes performances de correction pour tous les rendements de codage, notamment pour les rendements élevés.

Au vu des limitations des turbocodes actuels, discutées ci-dessus, il existe un besoin pour améliorer les performances de codage de symboles d'information mettant en œuvre un turbo-encodeur.

## Résumé

L'invention propose une solution nouvelle pour le codage d'un message numérique d'entrée, portant K symboles d'information, sous la forme d'un procédé de codage mettant en œuvre un turbo-encodeur formant un turbocode, le turbo-encodeur comportant un entrelaceur et des premier et deuxième encodeurs à encodage selon au moins un code élémentaire, délivrant les symboles d'information (entrelacés ou non) et des symboles de redondance.

Selon l'invention, un poinçonnage des symboles délivrés par le turbo-encodeur (symboles d'information et/ou de redondance) étant effectué suivant au moins un motif de poinçonnage périodique de longueur $N$, définissant la période de poinçonnage ledit entrelaceur répartit les symboles d'information dudit message d'entrée dans $Q$ couches du message d'entrée entrelacé en respectant une fonction d'entrelacement définie à partir dudit au moins un motif de poinçonnage, selon la relation :

$$\pi(i) = Pi + S(i \bmod Q) \bmod K = Pi + S(l) \bmod K = Pi + (T_l + A_l Q) \bmod K$$

avec :

- $i = 0, ..., K - 1$ la position d'un symbole d'information dans ledit message d'entrée entrelacé, dans l'ordre entrelacé, et $\pi(i)$ la position dudit symbole d'information dans ledit message d'entrée, dans l'ordre naturel ;
- $P$ une valeur entière première avec la longueur $K$ dudit message d'entrée, dite période de l'entrelaceur ;
- $S(i \bmod Q) = S(l) = T_l + A_l Q$ les paramètres d'ajustement de la fonction d'entrelacement, avec $l = 0, ..., Q - 1$ le numéro de la couche ;
- $Q$ degré de désordre inséré dans l'entrelaceur, correspondant au nombre de couches, tel que $Q = qN$, avec $q \geq 1$ un entier, et $Q$ un diviseur de $K$ ($P$ et $K$ étant premiers entre eux, et $K$ étant un multiple de $Q$, on note que $P$ et $Q$ sont premiers entre eux) ;
- $T_l$ une valeur d'ajustement inter-couches, définie à partir dudit au moins un motif de poinçonnage ; et
- $A_l$ une valeur d'ajustement intra-couche.

L'entrelacement mis en œuvre par le turbo-encodeur selon l'invention tient ainsi compte du ou des motifs de poinçonnage utilisés, pour entrelacer de façon astucieuse les symboles d'information du message d'entrée et améliorer les performances de codage/décodage.

On note que les symboles d'information du message d'entrée peuvent être considérés comme répartis, avant entrelacement, dans $Q$ couches (ou sous-ensembles) de $K/Q$ symboles d'information. L'entrelacement permet notamment de transformer une couche de symboles d'information du message d'entrée en une autre couche de symboles d'information du message d'entrée entrelacé. En d'autres termes, l'entrelaceur définit Q couches (ou sous-ensembles) de symboles d'information qui sont associées à Q valeurs différentes du paramètre d'ajustement $S(l)$.

Plus précisément, l'expression de l'entrelaceur selon le modèle mathématique $\pi(i) = Pi + (T_l + A_lQ)$ mod K montre la mise en œuvre d'un entrelacement à deux niveaux: chaque couche du message d'entrée non entrelacé est transformée par entrelacement en une autre couche du message d'entrée entrelacé (couche identique ou différente), et une position d'un symbole dans une couche du message d'entrée non entrelacé est transformée par entrelacement en une autre position dans une couche du message d'entrée entrelacé (position identique ou différente).

Plus précisément, la valeur d'ajustement inter-couches $T_l$ permet de fixer la correspondance entre les numéros de couches entre le message d'entrée non entrelacé et le message d'entrée entrelacé, $T_l \in (0, ..., Q - 1)$, en respectant des règles de connexion définies à partir du ou des motifs de poinçonnage. La valeur d'ajustement inter-couches $T_l$ peut ainsi être construite de façon déterministe.

Par exemple, si l'on considère que les symboles du message d'entrée sont répartis dans $Q$ couches (pour l'ordre naturel et pour l'ordre entrelacé), et si l'on note $j$ l'adresse d'un symbole dans le message d'entrée non entrelacé et $i$ son adresse dans le message d'entrée entrelacé ($j = \pi(i)$), alors dans le message d'entrée non entrelacé, le symbole appartient à la couche $j \bmod Q$, et dans le message d'entrée entrelacé, le symbole appartient à la couche $i \bmod Q$.

En d'autres termes, si le symbole d'adresse $i$ dans le message d'entrée entrelacé (ordre entrelacé) est situé dans la couche $l$, le symbole correspondant dans le message d'entrée non entrelacé (ordre naturel) provient de la couche $(Pxl + T_l)$ mod $Q$ (i.e. numéro de couche de $\pi(i)$).

La valeur d'ajustement intra-couche $A_l$ fixe quant à elle la position d'un symbole dans la couche $(P{\times}l + T_l)$ mod $Q$ avant entrelacement ($l$ étant le numéro de couche après entrelacement), $A_l \in (0, ..., (K/Q) - 1)$.

On note que les entrelaceurs ARP, DRP, ou QPP notamment peuvent être modélisés sous la forme d'un entrelaceur ARP selon le modèle mathématique $\pi(i) = Pi + S(i \bmod Q)$ mod $K$, et par suite selon le modèle mathématique $\pi(i) = Pi + (T_l + A_lQ)$ mod $K$ selon l'invention.

On note par ailleurs que différents motifs de poinçonnage peuvent être utilisés pour poinçonner les symboles d'information, les symboles de redondance obtenus à partir du premier encodeur, et les symboles de redondance obtenus à partir du deuxième encodeur. Par exemple, un premier motif de poinçonnage peut être utilisé pour poinçonner les symboles d'information, un deuxième motif de poinçonnage peut être utilisé pour poinçonner les symboles de redondance obtenus à partir du premier encodeur, et un troisième motif de poinçonnage peut être utilisé pour poinçonner les symboles de redondance obtenus à partir du deuxième encodeur. Ces différents motifs, identiques ou différents, présentent une longueur identique égale à $N$, encore appelée période de poinçonnage.

En particulier, un poinçonnage des symboles d'information délivrés par le turbo-encodeur étant effectué suivant un motif de poinçonnage de longueur $N$, la valeur d'ajustement inter-couches $T_l$ fait correspondre les symboles d'information poinçonnés entre eux, i.e. entre leur position dans l'ordre naturel et leur position dans l'ordre entrelacé.

De cette façon, l'entrelaceur respecte la règle de connexion selon laquelle la fonction d'entrelacement transforme la position poinçonnée d'un symbole d'information dans l'ordre naturel en une position poinçonnée pour le symbole d'information entrelacé correspondant.

Un entrelaceur selon l'invention peut notamment être construit en mettant en œuvre un procédé de construction d'un entrelaceur pour un turbo-encodeur formant un turbocode destiné à coder un message numérique d'entrée, le turbo-encodeur comportant des premier et deuxième encodeurs à encodage selon au moins un code élémentaire, selon un mode de réalisation le premier encodeur formant, à partir du message d'entrée, un premier ensemble de symboles d'information et de symboles de redondance, le deuxième encodeur formant, à partir du message d'entrée entrelacé par l'entrelaceur, un deuxième ensemble de symboles d'information et de symboles de redondance, un poinçonnage des symboles transmis par les deux encodeurs étant effectué suivant un motif de poinçonnage de longueur N définissant la période de poinçonnage $N$, le procédé comportant les étapes consistant à :

a) établir une fonction d'entrelacement de l'entrelaceur en fonction du motif de poinçonnage, en déterminant les degrés de fragilité des différentes positions au sein du motif et en connectant les positions selon au moins une règle de connexion de ladite fonction d'entrelacement, dépendante du degré de fragilité des positions,

b) déterminer un ensemble restreint de candidats pour les paramètres d'ajustement de la fonction d'entrelacement déterminée en a) en fonction de valeurs prédéfinies de la distance cumulée spatiale minimale $S_{min}$ et de la longueur du cycle minimal de corrélation $G_{min}$ de l'entrelaceur, pour au moins une période d'entrelaceur, et

c) sélectionner au moins un entrelaceur parmi l'ensemble restreint de candidats de l'étape b), sur la base au moins des spectres des distances des turbocodes obtenus en utilisant les entrelaceurs correspondants.

Le degré de fragilité d'une position, défini dans la suite, dépend de la distance minimale de Hamming du spectre des distances des codes élémentaires, et/ou du nombre de symboles de redondance poinçonnés dans le cas d'une position pour laquelle le symbole d'information est poinçonné.

Le procédé de construction de l'entrelaceur prend ainsi en compte le motif de poinçonnage lors de la construction de la fonction d'entrelacement du turbocode, permettant de réduire significativement l'espace de recherche des paramètres d'entrelacement, et d'obtenir un entrelaceur présentant des améliorations de performance importantes à faible taux d'erreurs par rapport aux méthodes connues, par exemple entre 0,5 et 1,5 dB de gain typique par rapport au code LTE.

Le turbocode formé selon l'invention peut appartenir à la même famille de codes standardisés que les codes utilisés dans les normes de téléphonie mobile de troisième génération, dite « 3G », et de quatrième génération, dite « 4G », mais présente des performances significativement améliorées pour une complexité équivalente.

Selon ce nouveau procédé, les paramètres d'entrelacement déterminés sont adaptés à chaque rendement $R$ de codage. La fonction d'entrelacement permet en outre de conserver la structure des motifs de poinçonnage, aussi bien pour les symboles d'information que pour les symboles de redondance.

Etablir la ou les règles de connexion de la fonction d'entrelacement selon le degré de fragilité des positions du motif de poinçonnage permet de répartir le pouvoir de correction du turbocode sur l'ensemble des symboles d'information, et a pour but de compenser les défauts de protection de chaque code élémentaire vis-à-vis de certains symboles d'information au sein du message à coder, en particulier, dans la période de poinçonnage.

Un tel procédé de construction de l'entrelaceur permet de réduire considérablement l'espace de recherche des paramètres d'ajustement de la fonction d'entrelacement par rapport à une recherche exhaustive ou aléatoire.

### *Sélection du motif de poinçonnage*

Le poinçonnage est ainsi périodique, se répétant suivant le motif de longueur N définissant la période de poinçonnage.

Dans le cas où chaque code élémentaire produit une seule sortie de redondance, le motif de poinçonnage associé à chaque code élémentaire est, de manière connue, constitué de deux vecteurs de longueur N, l'un pour le poinçonnage des symboles d'information, l'autre pour le poinçonnage des symboles de redondance. Dans le cas où chaque code élémentaire produit plusieurs sorties de redondance, le motif de poinçonnage est alors constitué d'un nombre de vecteurs plus élevé, dépendant du nombre de sorties de redondance, par exemple *r + 1* vecteurs de poinçonnage de longueur *N* pour *r* redondances du code élémentaire.

Le rendement de codage R d'un turbocode peut s'exprimer comme :

$$R = \frac{N}{N(1-R_{pd})+2N_{np}},$$

avec $R_{pd}$ le ratio de symboles d'information poinçonnés durant la période *N,* et $N_{np}$ le nombre de symboles de redondance non poinçonnés par code élémentaire dans la période *N.*

Les valeurs du rendement $R$ et de la période $N$ du motif étant fixés, le ratio $R_{pd}$ peut prendre $N$+1 valeurs possibles :

$$R_{pd} = \frac{n}{N},$$

*n = 0, ..., N.*

En pratique, seules les valeurs conduisant à des rendements $R_c$ des codes élémentaires inférieurs à 1 sont admissibles. Dans le cas contraire, les décodeurs élémentaires correspondants ne sont pas capables de reconstruire le message transmis à partir des symboles reçus.

En d'autres termes, la limite admissible correspond au cas où le nombre total de symboles d'information et de redondance délivrés par les codes élémentaires devient inférieur à la taille K du message d'entrée.

Le motif de poinçonnage est par exemple sélectionné indépendamment de l'entrelaceur.

Selon un mode de réalisation, le motif de poinçonnage est sélectionné préalablement parmi une pluralité de motifs de poinçonnage correspondant à différentes valeurs admissibles du ratio $R_{pd}$ de symboles d'information poinçonnés durant la période de poinçonnage *N,* sur la base au moins d'une comparaison entre les spectres des distances des codes élémentaires poinçonnés correspondants et de mesures d'information mutuelle échangée entre les informations extrinsèques entrante et sortante du décodeur correspondant à l'encodeur dans le cas où ces motifs de poinçonnage sont utilisés avec un entrelaceur uniforme.

Selon un mode de réalisation, pour chaque valeur de période de poinçonnage *N* et du ratio $R_{pd}$, une valeur représentative d'une distance du spectre des distances du code élémentaire poinçonné, correspondant notamment à la distance minimale de Hamming, est utilisée pour la comparaison entre les spectres des distances du code élémentaire poinçonné, le motif de poinçonnage conduisant à la plus grande valeur de distance étant sélectionné.

Pour ce faire, pour chaque valeur de période N sélectionnée et pour chaque valeur du ratio $R_{pd}$, on peut considérer tous les motifs de poinçonnage possibles et déterminer pour chacun d'eux le début du spectre des distances du code élémentaire poinçonné, c'est-à-dire la distance minimale de Hamming du code et les distances immédiatement supérieures, ainsi que leur multiplicité. On peut utiliser l'algorithme FAST décrit dans l'article de M. Cedervall et R. Johannesson, "A fast algorithm for computing distance spectrum of convolutional codes" IEEE Trans. Inf. Theory, vol. 35, no. 6, pp. 1146-1159, Nov. 1989, et adapté aux codes poinçonnés.

Plusieurs motifs de poinçonnage conduisant à la même plus grande valeur de distance pour une même valeur de période de poinçonnage $N$ et une même valeur du ratio $R_{pd}$, on sélectionne par exemple le motif dont la multiplicité est minimale.

Plusieurs motifs de poinçonnage conduisant à la même valeur de multiplicité minimale correspondant à une même plus grande valeur de distance, pour une même valeur de période $N$ et une même valeur du ratio $R_{pd}$, le processus de sélection du motif est réitéré pour la distance suivante, c'est-à-dire immédiatement supérieure, dans le spectre des distances du code élémentaire poinçonné.

Cette première partie de la sélection du motif de poinçonnage permet d'éliminer les motifs dits catastrophiques.

Pour chaque valeur de période $N$ et du ratio $R_{pd}$, on sélectionne par exemple, parmi les motifs précédemment sélectionnés, le motif de poinçonnage conduisant à une valeur de l'information mutuelle échangée supérieure ou égale à celle obtenue lorsque le ratio $R_{pd}$ de symboles d'information poinçonnés est nul.

L'entrelaceur uniforme utilisé pour calculer les valeurs de l'information mutuelle échangée est un entrelaceur probabiliste qui produit tous les entrelacements possibles pour une taille $K$ de séquence d'information de manière équiprobable, par exemple généré par un tirage aléatoire pour chaque séquence transmise, et comme décrit dans l'article de S. Benedetto et G. Montorsi, "Unveiling turbo codes: some results on parallel concatenated coding schemes" IEEE Trans. Inf. Theory, vol. 42, no. 2, pp. 409-428, 1996. L'entrelaceur uniforme permet d'évaluer les performances moyennes du turbocode, indépendamment du choix de l'entrelaceur.

Le décodeur correspondant à un entrelaceur uniforme du turbocode peut être simulé pour les motifs de poinçonnage sélectionnés à l'étape précédente, afin de comparer les courbes de taux d'erreurs obtenues.

Selon un mode de réalisation particulier, le motif de poinçonnage sélectionné est celui offrant le meilleur compromis entre les performances à fort et moyen taux d'erreurs dans la région d'àpic et les performances à faibles taux d'erreurs dans la région d'évasement, en fonction notamment de l'application visée.

En particulier, la période N de poinçonnage est un diviseur de la longueur K du message numérique d'entrée. Ceci permet de limiter les effets de bord liés au poinçonnage.

Afin de limiter l'espace de recherche des entrelaceurs, il peut être avantageux de ne considérer en pratique pour la période $N$ que les plus petits diviseurs de la taille K du message numérique d'entrée, par exemple dans le cas où K est divisible par 256, seules des périodes de poinçonnage égales à 8 ou 16 peuvent être considérées.

Les motifs de poinçonnage sont de préférence identiques pour les deux codes élémentaires formant le turbocode, notamment dans le cas où les codes élémentaires sont identiques.

### *Fonction d'entrelacement*

Les entrelaceurs utilisés dans l'invention appartiennent de préférence à la famille des entrelaceurs ARP. L'invention n'est toutefois pas limitée à un type particulier d'entrelaceur. En particulier, comme déjà indiqué, les entrelaceurs DRP et QPP peuvent être modélisés sous la forme d'entrelaceurs ARP.

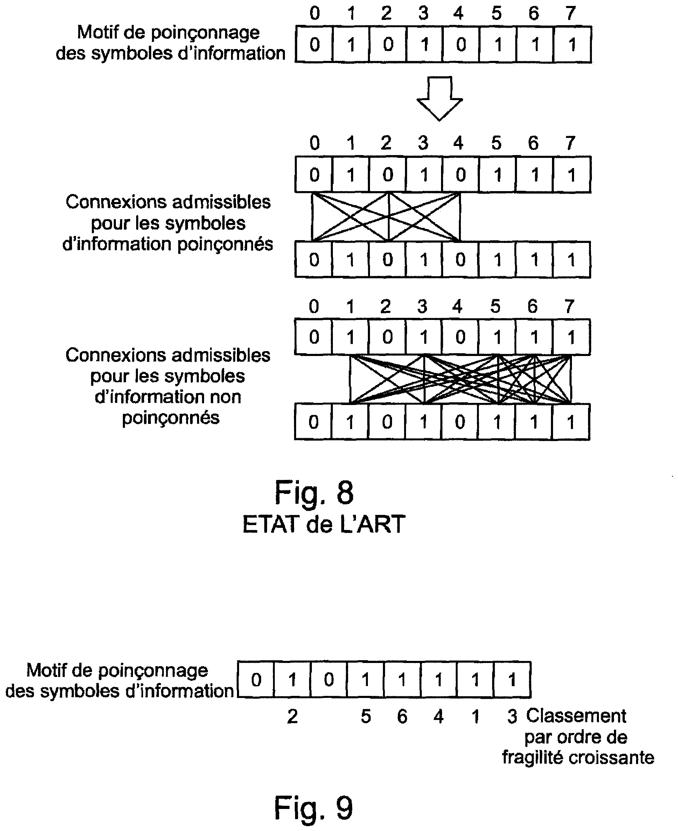

De manière connue, les symboles d'information à la fois utilisés en entrée du code élémentaire C1 et en entrée du code élémentaire C2, n'étant transmis qu'une fois, un symbole poinçonné pour l'un des codes doit nécessairement être poinçonné pour l'autre code. Par conséquent, la fonction d'entrelacement transforme la position poinçonnée d'un symbole d'information dans l'ordre naturel en une position poinçonnée pour le symbole d'information entrelacé correspondant, comme représenté à la figure 8, pour une période N de poinçonnage égale à 8. Cette règle est décrite notamment dans les articles de S. Crozier et al. susmentionnés, et dans la demande US 2007/0288834. Cette règle ne s'applique pas aux symboles de redondance, chaque symbole de redondance étant propre à un seul code.

### *- Degrés de fragilité*

La détermination du degré de fragilité de chaque position du symbole d'information vis-à-vis du code élémentaire au sein du message à coder dans la période de poinçonnage peut être fonction de s'il s'agit d'une position pour laquelle le symbole d'information est poinçonné ou non. En d'autres termes, la procédure mise en œuvre est différente si la position du symbole d'information dans le message d'entrée correspond à une position pour laquelle le symbole d'information est poinçonné ou à une position pour laquelle le symbole d'information est non poinçonné.

Dans le cas de positions pour lesquelles le symbole d'information correspondant n'est pas poinçonné, le degré de fragilité des positions est par exemple déterminé sur la base au moins d'une comparaison des spectres des distances des codes élémentaires obtenus en poinçonnant un par un chacun des symboles d'information non poinçonnés, la position la moins fragile correspondant au spectre ayant la distance minimale de Hamming la plus grande et la multiplicité la plus faible, et la position la plus fragile correspondant au spectre ayant la distance minimale de Hamming la plus faible et la multiplicité la plus grande.

En cas d'égalité de la distance minimale de Hamming et des multiplicités, la comparaison est réitérée pour la distance immédiatement supérieure dans le spectre des distances.

Un classement des positions selon leur degré de fragilité peut être effectué, dont un exemple est représenté à la figure 9, pour un motif de poinçonnage de longueur $N$ = 8. La valeur '1' correspond à la position la moins fragile, la valeur '6' à la position la plus fragile.

Dans le cas de positions pour lesquelles le symbole d'information est poinçonné, le degré de fragilité des positions est par exemple déterminé en fonction du nombre de symboles de redondance poinçonnés, les positions les moins fragiles étant celles pour lesquelles aucun symbole de redondance n'est poinçonné et les plus fragiles celles pour lesquelles tous les symboles de redondance sont poinçonnés. Les degrés de fragilité intermédiaires peuvent être déterminés en fonction du nombre de symboles de redondance poinçonnés, la position étant d'autant plus fragile que le nombre de symboles de redondance poinçonnés est élevé.

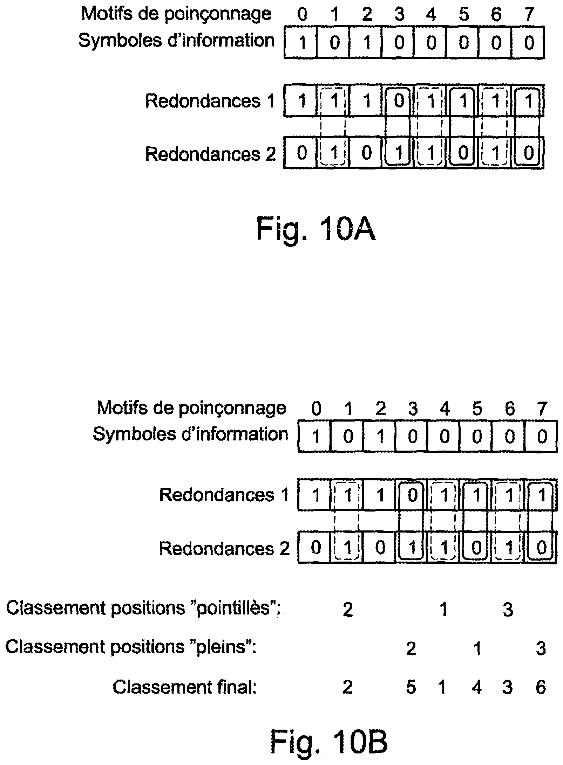

La figure 10A illustre un exemple de détermination de degrés de fragilité de positions pour lesquelles le symbole d'information est poinçonné, pour un motif de poinçonnage de longueur $N$ = 8. Deux classes de degrés de fragilité sont déterminées par le nombre de symboles de redondance poinçonnés : les positions repérées en traits pointillés, correspondant à un symbole de redondance poinçonné, sont plus fragiles que les positions repérées en traits pleins, correspondant à aucun symbole de redondance poinçonné.

Les degrés de fragilité des positions ayant le même nombre de symboles de redondance poinçonnés peuvent être déterminés sur la base au moins d'une comparaison des spectres des distances des codes élémentaires obtenus en poinçonnant un par un chacun des symboles de redondance non poinçonnés, la position la moins fragile correspondant au spectre ayant la distance minimale de Hamming la plus grande et la multiplicité la plus faible, et la position la plus fragile correspondant au spectre ayant la distance minimale de Hamming la plus faible et la multiplicité la plus grande.

La figure 10B illustre cette étape à partir de l'exemple de la figure 10A, en montrant le classement par degré croissant de fragilité des positions repérées en traits pointillés et en traits pleins, et le classement final global. La valeur '1' correspond à la position la moins fragile, la valeur '6' à la position la plus fragile.

Dans le cas où plusieurs symboles de redondance sont non poinçonnés, ceux-ci peuvent être poinçonnés un par un, le spectre des distances étant déterminé pour chacun d'entre eux et le classement final des positions selon leur degré de fragilité prenant en compte l'ensemble des spectres obtenus pour chacune des positions.

Un classement de l'ensemble des positions selon leur degré de fragilité peut être effectué.

*- Règles de connexion*

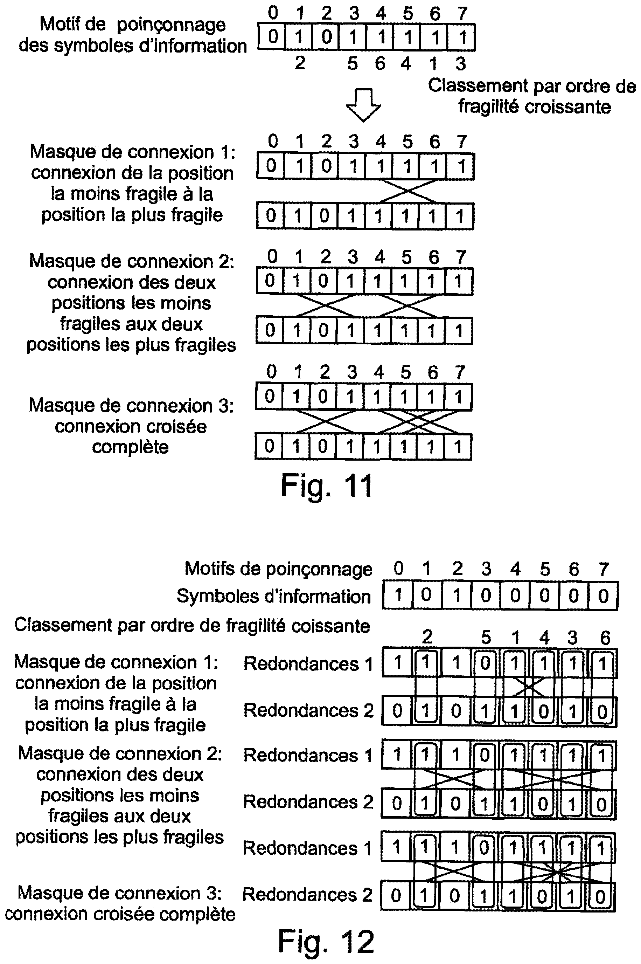

Selon une première règle de connexion de la fonction d'entrelacement, pour les positions pour lesquelles le symbole d'information n'est pas poinçonné, les positions les plus fragiles sont connectées aux positions les moins fragiles, la position la plus fragile étant notamment connectée à la position la moins fragile, la deuxième position la plus fragile étant notamment connectée à la deuxième position la moins fragile, et ainsi de suite, comme représenté à la figure 11, pour un motif de poinçonnage de longueur $N$ = 8.

Selon une deuxième règle de connexion de la fonction d'entrelacement, pour les positions pour lesquelles le symbole d'information est poinçonné, les positions les plus fragiles sont connectées aux positions les moins fragiles, la position la plus fragile étant notamment connectée à la position la moins fragile, la deuxième position la plus fragile étant notamment connectée à la deuxième position la moins fragile, et ainsi de suite, comme représenté à la figure 12, pour un motif de poinçonnage de longueur $N$ = 8.

Ces règles de connexion sont complémentaires avec la règle décrite précédemment, selon laquelle la fonction d'entrelacement transforme la position poinçonnée d'un symbole d'information dans l'ordre naturel en une position poinçonnée pour le symbole d'information entrelacé correspondant. Ces règles de connexion peuvent être appliquées conjointement ou non.

Chaque règle de connexion peut concerner un nombre limité de positions ou l'ensemble des positions pour arriver à une connexion croisée complète.

*- Paramètres d'ajustement*

Selon un mode de réalisation particulier, la valeur prédéfinie de la distance cumulée spatiale minimale $S_{min}$ de l'entrelaceur est inférieure ou égale au plus grand entier inférieur à la racine carrée du double de la longueur $K$ du message numérique d'entrée $S_{min} = \left\lfloor \sqrt{2K} \right\rfloor$, et la valeur prédéfinie de la longueur du cycle minimal de corrélation $G_{min}$ de l'entrelaceur est inférieure ou égale à la borne théorique de Moore $\lfloor 2\log_3(K) \rfloor$.

Comme défini dans l'article de N. Biggs "Minimal regular graphs with given girth", Algebraic graph theory, Cambridge University Press, 1974, pp. 180-190, dans un graphe régulier où tous les nœuds ont le même nombre de voisins, la borne de Moore correspond à une longueur du cycle minimal inférieure ou égale à $2\ log_{r-1}(S)$, où $r$ est le degré du graphe, c'est-à-dire le nombre de voisins de chaque nœud, et $S$ le nombre de nœuds du graphe. Dans le cas de l'entrelaceur d'un turbocode, $r$ est égal à 4 et $S = K$, $G_{min}$ admet donc comme borne supérieure de Moore : $\lfloor 2\log_3(K) \rfloor$.

La distance cumulée spatiale minimale, ou « *span minimal* » en anglais, permet de mesurer la capacité de l'entrelaceur à disperser efficacement les paquets d'erreurs.

La distance cumulée spatiale d'un couple de symboles est défini comme la somme de la distance spatiale entre les deux symboles avant et après entrelacement.

Dans le cas où le code est circulaire, la distance cumulée spatiale s'exprime comme :

$$S\ (i,j)\ =\ f\ (i,j)\ +\ f\ (\Pi(i),\Pi(j)),$$

où

$$f\ (u,v)\ =\ min[|u - v|\ , K - |u - v|].$$

La distance cumulée spatiale minimale de l'entrelaceur est alors égale à :

$$S_{min} =\ \min_{i,j\in\{0,...K-1\},i\neq j}[S\ (i,j\ )].$$

La valeur prédéfinie de la distance cumulée spatiale minimale correspond à la borne supérieure de cette dernière, démontrée dans l'article de E. Boutillon et D. Gnaedig, "Maximum spread of D-dimensional multiple turbo codes," IEEE Trans. Commun., vol. 53, no. 8, pp. 1237-1242, 2005.

La longueur du cycle minimal de corrélation $G_{min}$, ou «*girth minimal*» en anglais, de l'entrelaceur provient de la construction du graphe de corrélation entre la séquence de symboles dans l'ordre naturel et la séquence de symboles dans l'ordre entrelacé, décrit dans l'article de Y. Saouter, "Selection procedure of turbocode parameters by combinatorial optimization", Int. Symposium on Turbo Codes and Iterative Information Processing (ISTC), Sept. 2010, pp. 156-160.

Dans le processus de décodage itératif d'un turbocode, un niveau de corrélation élevé entre les symboles codés peut induire une dégradation des performances de correction du code, par propagation des erreurs au fil des itérations. Le symbole décodé par un des décodeurs à la position $i$ dans le message dépend du symbole reçu à la position $i$, des symboles reçus aux positions voisines de $i$, et de l'information extrinsèque relative au symbole $i$ provenant de l'autre décodeur par le biais de l'entrelaceur.

Le niveau de corrélation dans le processus de décodage est d'autant plus faible que les cycles dans le graphe de corrélation sont longs. La longueur du cycle minimal de corrélation $G_{min}$ correspond à la longueur du cycle le plus court du graphe de corrélation. Cette valeur est limitée par la borne de Moore, comme expliqué dans l'article de N. Biggs, "Minimal regular graphs with given girth", Algebraic graph theory, Cambridge University Press, 1974, pp. 180-190. En outre, il est préférable de ne pas avoir des valeurs trop faibles pour limiter les effets de la corrélation. Pour des messages à encoder de longueur supérieure ou égale à 1000 bits, une valeur minimale de longueur de cycle de corrélation égale à 8 peut être suffisante. Pour des messages plus courts, il est préférable d'obtenir des valeurs minimales les plus proches possibles de la borne de Moore, un écart de 3 points en-dessous de la borne étant acceptable.

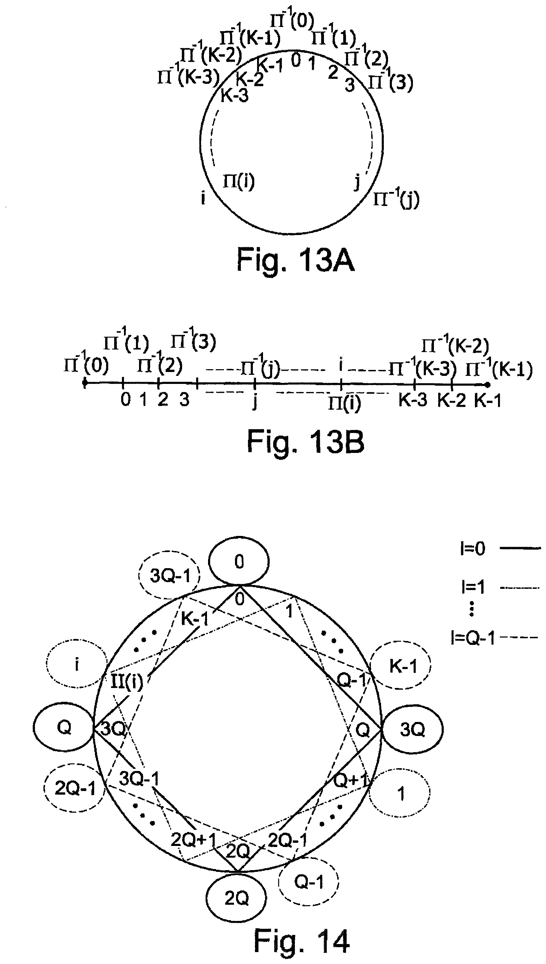

Dans la suite, la construction progressive de la fonction d'entrelacement sera illustrée sous la forme graphique représentée aux figures 13A et 13B. Cette représentation permet d'introduire aisément les règles de connexion liées au poinçonnage, de construire progressivement l'entrelaceur et de vérifier à chaque étape les valeurs de distance cumulée spatiale minimale $S_{min}$ et de longueur du cycle minimal de corrélation $G_{min}$ de l'entrelaceur. La figure 13A correspond au cas d'un code circulaire, les adresses à l'intérieur du cercle représentant le placement des symboles d'information dans l'ordre naturel non entrelacé et les adresses à l'extérieur du cercle représentant les positions des mêmes symboles d'information après entrelacement. La figure 13B correspond au cas d'un code non circulaire, les adresses inférieures représentant le placement des symboles d'information dans l'ordre naturel non entrelacé et les adresses supérieures représentant les positions des mêmes symboles d'information après entrelacement.

Le modèle mathématique de l'entrelaceur ARP peut conduire à :

$$\Pi(i + Q) \bmod Q = \Pi(i) \bmod Q.$$

La valeur du degré de désordre $Q$ étant déterminée, on peut regrouper les adresses d'entrelacement en $Q$ couches, comme représenté à la figure 14 dans le cas particulier d'un message d'entrée de longueur $K=4Q$, et traiter les couches les unes après les autres pour le choix des paramètres d'ajustement de l'entrelaceur.

Par exemple, le degré de désordre $Q$ de l'entrelaceur est un multiple de la période de poinçonnage $N$. Dans la suite, il est admis que $Q = N$. Dans le cas où $Q = qN$, $q > 1$, il est possible de concaténer q motifs de poinçonnage identiques pour arriver à la longueur $Q$. Etant donné que $\Pi(i + Q) \bmod Q = \Pi(i) \bmod Q$, la validation des règles de poinçonnage sur une période $Q$ est une condition suffisante pour qu'elle soit validée sur la totalité du message d'entrée.

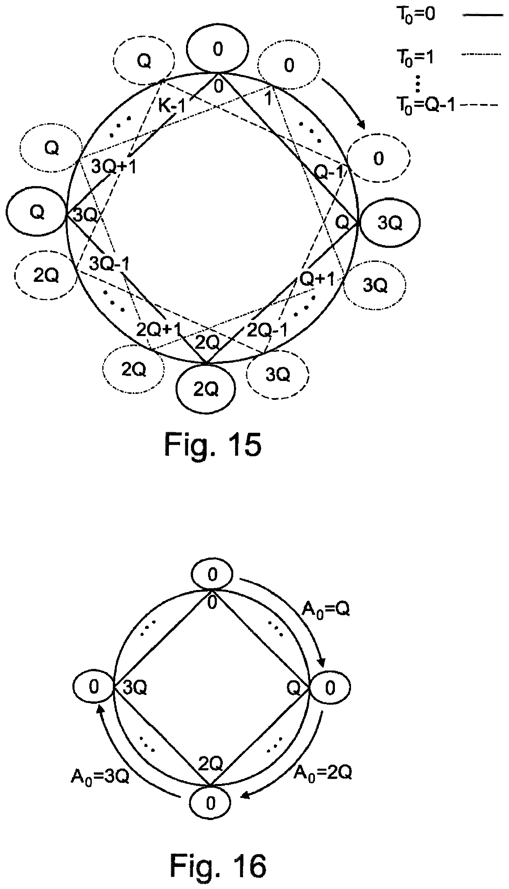

Les paramètres d'ajustement $S(l)$ de la fonction d'entrelacement peuvent s'exprimer par $S(l) = T_l + A_l.Q$, avec $l = 0, ..., Q - 1$ le numéro de la couche après entrelacement, $T_l$ étant la composante inter-couche, $A_l$ la composante intra-couche, et $Q$ le degré de désordre inséré dans l'entrelaceur correspondant au nombre de couches. Ceci permet de couvrir toutes les adresses possibles pour chaque couche. L'ajustement inter-couches $T_l$ fixe la correspondance entre les numéros de couche avant et après entrelacement, chaque couche étant transformée par entrelacement en une autre couche, comme représenté à la figure 15, tandis que l'ajustement intra-couche $A_l$ définit la rotation opérée par l'entrelacement à l'intérieur d'une couche (i.e. la position d'un symbole à l'intérieur d'une couche), comme représenté à la figure 16, pour la couche $l = 0$ et $K = 4Q$.

La valeur de chaque paramètre d'ajustement $S(l)$ est de préférence obtenue en sélectionnant séparément la valeur de l'ajustement inter-couches $T_l$ et la valeur de l'ajustement intra-couche $A_l$.

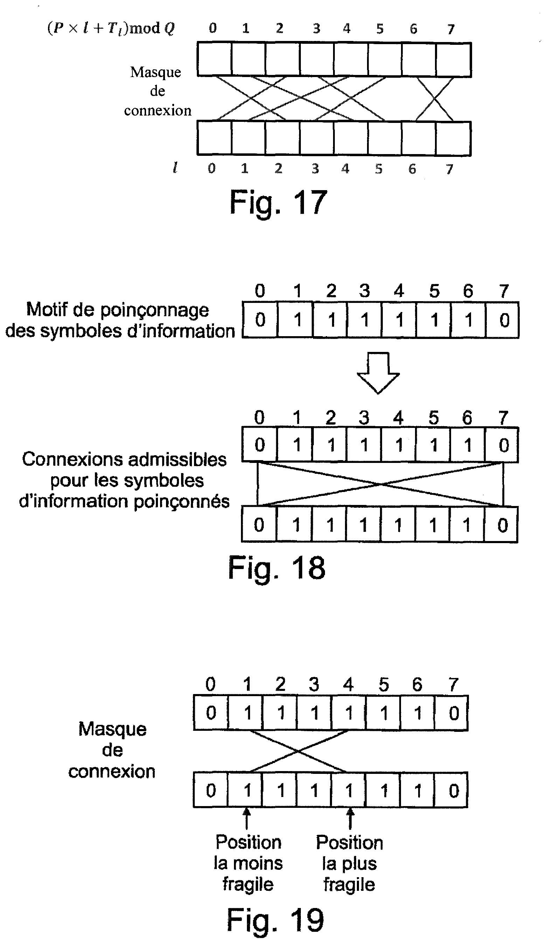

Comme représenté à la figure 17, pour $Q = 8$, un lien peut être établi entre les positions connectées, formant un masque de connexion, et la valeur de l'ajustement inter-couches $T_l$ :

$$\{(l, (P \times l + T_l) \bmod Q), l = 0, ..., 7\} = \{(0,2), (1,4), (2,0), (3,5), (4,1), (5,3), (6,7), (7,6)\}.$$

Pour respecter la règle de connexion selon laquelle la fonction d'entrelacement transforme la position poinçonnée d'un symbole d'information dans l'ordre naturel en une position poinçonnée pour le symbole d'information entrelacé correspondant, on peut ne considérer que les valeurs de l'ajustement inter-couches $T_l$ qui font correspondre les symboles d'information poinçonnés entre eux. Pour respecter la première règle de connexion, on peut ne considérer que les valeurs de l'ajustement inter-couches $T_l$ qui font correspondre les positions des symboles d'information non poinçonnés les plus fragiles aux positions des symboles d'information non poinçonnés les moins fragiles. Pour respecter la deuxième règle de connexion, on peut ne considérer que les valeurs de l'ajustement inter-couches $T_l$ qui font correspondre les positions des symboles d'information poinçonnés les plus fragiles aux positions des symboles d'information poinçonnés les moins fragiles. Ceci permet de réduire l'espace de recherche des valeurs d'ajustement inter-couche $T_l$ et du vecteur d'ajustement $S = (T_0 + A_0Q, T_1 + A_1Q,..., T_{Q-1} + A_{Q-1}Q)$.

La période d'entrelaceur P est par exemple une valeur entière première avec la longueur K du message numérique d'entrée, adaptée pour garantir une valeur de distance cumulée spatiale minimale $S_{min}$ de l'entrelaceur supérieure ou égale à la distance cumulée spatiale minimale dans le cas où l'entrelaceur est régulier.

Pour chaque valeur de la période d'entrelaceur P, un graphe d'entrelacement peut être établi en intégrant les connexions d'entrelacement au fur et à mesure que les paramètres d'ajustement $S(l)$ sont déterminés selon la fonction d'entrelacement, pour chaque couche $l$, en contrôlant les valeurs de distance cumulée spatiale minimale $S_{min}$ et de longueur du cycle minimal de corrélation $G_{min}$ de l'entrelaceur.

Au départ, seules les positions correspondant aux symboles d'information non entrelacés sont de préférence présentes, les connexions d'entrelacement étant ajoutées au fur et à mesure que les valeurs de $S(l)$ sont choisies, pour chaque valeur de $l = 0 ... Q - 1$, en fonction des règles de connexion liées au motif de poinçonnage. Pour chaque valeur du paramètre $S(l)$, les valeurs de distance cumulée spatiale minimale $S_{min}$ et de longueur du cycle minimal de corrélation $G_{min}$ peuvent être calculées. Si elles sont supérieures ou égales aux valeurs prédéfinies, on passe à la couche suivante $l + 1$. Dans le cas contraire, une autre valeur du paramètre $S(l)$ est testée.

Le processus de construction du graphe d'entrelacement est de préférence poursuivi jusqu'à la dernière couche, correspondant à $l = Q - 1$.

Si le processus de construction du graphe d'entrelacement ne converge pas, c'est-à-dire qu'on ne trouve pas un jeu de paramètres $S(l)$ satisfaisant la fonction d'entrelacement et conduisant à des valeurs admissibles de distance cumulée spatiale minimale $S_{min}$ et de longueur du cycle minimal de corrélation $G_{min}$, le processus peut être réitéré pour la valeur suivante de période d'entrelaceur P.

Si le processus ne converge pour aucune des valeurs de période d'entrelaceur P, l'une ou les valeurs prédéfinies de distance cumulée spatiale minimale $S_{min}$ et de longueur du cycle minimal de corrélation $G_{min}$ peuvent être diminuées, et le processus relancé.

Le spectre des distances des turbocodes obtenus en utilisant les entrelaceurs de l'ensemble restreint de candidats obtenu peut être estimé. On sélectionne par exemple l'entrelaceur conduisant à un spectre des distances présentant au moins la plus grande valeur de distance minimale, et en particulier la multiplicité la plus faible. En cas d'égalité, on considère la distance immédiatement supérieure.

Une démarche similaire peut être appliquée pour restreindre le choix des paramètres d'ajustement pour d'autres familles d'entrelaceurs, par exemple pour le choix des paramètres $f_1$ et $f_2$ d'un entrelaceur QPP, adopté dans le standard LTE.

L'invention porte encore, selon un autre de ses aspects, sur un entrelaceur pour un turbo-encodeur formant un turbocode destiné à coder un message numérique d'entrée utilisé par le procédé de codage selon l'invention.

### Codes élémentaires

Selon un mode de réalisation particulier, les deux codes élémentaires des premier et deuxième encodeurs du turbo-encodeur sont identiques.

Selon un mode de réalisation particulier, les codes élémentaires des premier et deuxième encodeurs du turbo-encodeur sont circulaires.

L'efficacité des codes circulaires est connue. En effet, la plupart des systèmes de communications considèrent la transmission de l'information par blocs. Les codes convolutifs, et par conséquent les turbocodes, sont bien adaptés à la transmission des données par blocs à la condition que les décodeurs correspondants puissent déterminer l'état des encodeurs au début et à la fin du codage du bloc d'information, dit « *terminaison de treillis* ». Parmi les différentes techniques de terminaison de treillis connues, la technique d'encodage circulaire (« *tail-biting* » en anglais) s'applique avantageusement aux turbocodes. Dans cette technique, décrite dans les articles de H. Ma et J. K. Wolf "On tail-biting convolutional codes", IEEE Trans. Commun., vol. 34, no 2, pp. 104-111, 1986, et de C. Weiss et al., "Turbo decoding with tail-biting trellises", URSI Intern. Symp. on Signals, Systems, and Electronics (ISSSE), Oct. 1998, pp. 343-348, et "Code construction and decoding of parallel concatenated tail-biting codes", IEEE Trans. Inform. Theory, vol. 47, pp. 366-386, Jan. 2001, le treillis d'encodage de chacun des codes élémentaires est rendu circulaire, c'est-à-dire que l'état initial et l'état final d'encodage du bloc d'information sont identiques.

L'encodage circulaire a été adopté dans des standards tels que DVB-RCS/RCS2, DVB-RCT et WiMAX. Cette technique représente la meilleure méthode de terminaison de treillis pour les turbocodes car elle n'introduit ni perte d'efficacité spectrale ni aucun effet de bord dans l'encodage et le décodage itératif du message transmis. Tous les symboles d'information sont par conséquent protégés de manière identique par le turbocode avant poinçonnage, et la propriété de circularité permet d'éviter la présence de mots de codes tronqués de poids faibles, comme cela se produit souvent avec des symboles de terminaison, par exemple dans le turbocode adopté dans les normes 3G, LTE ou LTE-Advanced. En outre, la terminaison ne produisant pas de position dans le treillis requérant de traitement particulier, la conception de l'entrelaceur en est simplifiée.

Les codes élémentaires des premier et deuxième encodeurs du turbo-encodeur peuvent être le code CSR(13, 15)$_8$, ou le code CSR(13, 15, 17)$_8$.

### Produit programme d'ordinateur

L'invention porte encore, selon un autre de ses aspects, sur un programme d'ordinateur pour la mise en œuvre du procédé de codage décrit ci-dessus, téléchargeable depuis un réseau de communications et/ou enregistré sur un support lisible par ordinateur et/ou exécutable par un processeur.

Un produit programme d'ordinateur peut également être défini pour la mise en œuvre du procédé de construction d'un entrelaceur, téléchargeable depuis un réseau de communications et/ou enregistré sur un support lisible par ordinateur et/ou exécutable par un processeur,
le turbo-encodeur comportant des premier et deuxième encodeurs à encodage selon au moins un code élémentaire, selon un mode de réalisation le premier encodeur formant, à partir du message d'entrée, un premier ensemble de symboles d'information et de symboles de redondance, le deuxième encodeur formant, à partir du message d'entrée entrelacé par l'entrelaceur, un deuxième ensemble de symboles d'information et de symboles de redondance, un poinçonnage des symboles transmis par les deux encodeurs étant effectué suivant un motif de poinçonnage de longueur $N$, le produit programme d'ordinateur comprenant des instructions de code qui, exécutées sur un processeur, font que :

a) une fonction d'entrelacement de l'entrelaceur soit établie en fonction du motif de poinçonnage, en déterminant les degrés de fragilité des différentes positions au sein du motif et en connectant les positions selon au moins une règle de connexion de ladite fonction d'entrelacement, dépendante du degré de fragilité des positions,
b) un ensemble restreint de candidats soit déterminé pour les paramètres d'ajustement de la fonction d'entrelacement déterminée en a) en fonction de valeurs prédéfinies de la distance cumulée spatiale minimale et de la longueur du cycle minimal de corrélation de l'entrelaceur, pour au moins une période d'entrelaceur, et

c) au moins un entrelaceur soit sélectionné parmi l'ensemble restreint de candidats de l'étape b), sur la base au moins des spectres des distances des turbocodes obtenus en utilisant les entrelaceurs correspondants.

Les caractéristiques énoncées ci-dessus pour le procédé s'appliquent au produit programme d'ordinateur.

### *Turbo-encodeur*

L'invention porte encore, selon un autre de ses aspects, sur un turbo-encodeur mettant en œuvre le procédé de codage décrit ci-dessus.

Un tel turbo-encodeur peut bien sûr comporter les différentes caractéristiques relatives au procédé de codage selon l'invention, qui peuvent être combinées ou prises isolément. Ainsi, les caractéristiques et avantages de ce turbo-encodeur sont les mêmes que ceux du procédé de codage et ne sont pas détaillés plus amplement.

En particulier, le turbo-encodeur est obtenu en mettant en œuvre un procédé comportant les étapes consistant à :

a) pour chaque encodeur, sélectionner un motif de poinçonnage de longueur $N$ parmi une pluralité de motifs de poinçonnage correspondant à différentes valeurs admissibles du ratio $R_{pd}$ de symboles d'information poinçonnés durant la période de poinçonnage N définie par la longueur du motif, sur la base au moins d'une comparaison entre les spectres des distances des codes élémentaires poinçonnés correspondants et de mesures d'information mutuelle échangée entre les informations extrinsèques entrante et sortante du décodeur correspondant à l'encodeur dans le cas où ces motifs de poinçonnage sont utilisés avec un entrelaceur uniforme,

b) établir une fonction d'entrelacement de l'entrelaceur en fonction du motif de poinçonnage sélectionné, en déterminant les degrés de fragilité des différentes positions au sein du motif et en connectant les positions selon au moins une règle de connexion de ladite fonction d'entrelacement, dépendante du degré de fragilité des positions,

c) déterminer un ensemble restreint de candidats pour les paramètres d'ajustement de la fonction d'entrelacement déterminée en b) en fonction de valeurs prédéfinies de la distance cumulée spatiale minimale et de la longueur du cycle minimal de corrélation de l'entrelaceur, pour au moins une période d'entrelaceur, et

d) sélectionner au moins un entrelaceur parmi l'ensemble restreint de candidats de l'étape c), sur la base au moins des spectres des distances des turbocodes obtenus en utilisant les entrelaceurs correspondants.

Les caractéristiques énoncées ci- dessus pour le procédé s'appliquent au turbo-encodeur.

### *Procédé de transmission*

L'invention porte encore, selon un autre de ses aspects, sur un procédé de transmission d'un message numérique codé en utilisant un turbo-encodeur selon l'invention et destiné à être transmis via un canal de transmission.

### Description détaillée

L'invention pourra être mieux comprise à la lecture de la description détaillée qui va suivre, d'exemples de mise en œuvre non limitatifs de celle-ci, et à l'examen du dessin annexé, sur lequel :

- la figure 1A, précédemment décrite, représente la structure d'un turbo-encodeur selon l'art antérieur, et les figures 1B et 1C représentent la structure d'un turbo-encodeur selon différents modes de réalisation de l'invention,
- la figure 2, précédemment décrite, illustre le décodage itératif d'un turbocode selon l'art antérieur,
- la figure 3, précédemment décrite, représente des courbes de taux d'erreurs d'un turbocode décodé de manière itérative selon l'art antérieur,
- la figure 4, précédemment décrite, représente un entrelaceur d'un turbocode à codes élémentaires circulaires selon l'art antérieur,
- la figure 5 est un diagramme illustrant différentes étapes de mise en œuvre d'un procédé de construction d'un entrelaceur,
- la figure 6 représente des courbes de mesure de l'information mutuelle échangée entre les décodeurs correspondants au turbo-encodeur selon un exemple de réalisation, utilisées pour la sélection du motif de poinçonnage,
- la figure 7 représente des courbes de taux d'erreurs du turbo-décodeur correspondant à un entrelaceur uniforme pour différents motifs de poinçonnages sélectionnés,
- la figure 8, précédemment décrite, représente un exemple de règle de connexion d'une fonction d'entrelacement selon l'art antérieur,

**EP 3 311 495 B1**

- la figure 9, précédemment décrite, représente un classement de positions selon leur degré de fragilité pour lesquelles le symbole d'information n'est pas poinçonné,
- les figures 10A et 10B, précédemment décrites, illustrent la détermination du degré de fragilité des positions pour lesquelles le symbole d'information est poinçonné,
- les figures 11 et 12, précédemment décrites, illustrent des règles de connexion de la fonction d'entrelacement selon l'invention,
- les figures 13A et 13B, précédemment décrites, sont des exemples de représentations graphiques utilisées pour la construction de l'entrelaceur,
- la figure 14, précédemment décrite, illustre la découpe de l'entrelaceur en $Q$ couches,
- la figure 15, précédemment décrite, illustre un exemple d'ajustement inter-couches possibles,
- la figure 16, précédemment décrite, illustre un exemple d'ajustement intra-couches possibles,
- la figure 17, précédemment décrite, représente le lien entre les positions connectées et la valeur d'ajustement $T_l$,
- la figure 18 représente des connexions admissibles de l'entrelaceur pour les symboles d'information poinçonnés selon l'exemple de réalisation des figures 6 et 7,
- les figures 19 et 20 représentent des exemples de connexions imposées pour l'entrelacement des symboles d'information non poinçonnés selon la première règle de connexion de la fonction d'entrelacement selon l'invention,
- la figure 21 représente un exemple de masque de connexion pour les symboles d'information poinçonnés en fonction de leur degré de fragilité,
- la figure 22 montre des valeurs de distance cumulée spatiale minimale correspondant à des valeurs admissibles de la période d'entrelaceur régulier,
- la figure 23 représente des courbes de mesure de l'information mutuelle échangée entre les décodeurs correspondants au turbo-encodeur selon un autre exemple de réalisation, utilisées pour la sélection du motif de poinçonnage,
- la figure 24 représente des courbes de taux d'erreurs du turbo-décodeur correspondant à un entrelaceur uniforme pour différents motifs de poinçonnages sélectionnés ,
- la figure 25 montre des valeurs de distance cumulée spatiale minimale correspondant à des valeurs admissibles de la période d'entrelaceur régulier,
- la figure 26 représente des courbes de mesure de l'information mutuelle échangée entre les décodeurs correspondants au turbo-encodeur selon un autre exemple de réalisation, utilisées pour la sélection du motif de poinçonnage,
- la figure 27 représente des courbes de taux d'erreurs du turbo-décodeur correspondant à un entrelaceur uniforme pour différents motifs de poinçonnages sélectionnés ,
- la figure 28 représente des connexions admissibles de l'entrelaceur pour les symboles d'information poinçonnés selon l'exemple de réalisation des figures 26 et 27,
- les figures 29 et 30 représentent d'autres exemples de connexions imposées pour l'entrelacement des symboles d'information non poinçonnés selon la première règle de connexion de la fonction d'entrelacement selon l'invention,
- la figure 31 représente un autre exemple de masque de connexion pour les symboles d'information poinçonnés en fonction de leur degré de fragilité,
- la figure 32 représente des courbes de mesure de l'information mutuelle échangée entre les décodeurs correspondants au turbo-encodeur selon un autre exemple de réalisation, utilisées pour la sélection du motif de poinçonnage,
- la figure 33 représente des courbes de taux d'erreurs du turbo-décodeur correspondant à un entrelaceur uniforme pour différents motifs de poinçonnages sélectionnés selon un autre exemple de réalisation,
- la figure 34 représente des courbes de taux d'erreurs du turbo-décodeur correspondant à un entrelaceur uniforme pour différents motifs de poinçonnages sélectionnés,
- la figure 35 représente des connexions admissibles de l'entrelaceur pour les symboles d'information poinçonnés selon l'exemple de réalisation de la figure 34,
- la figure 36 représente un autre exemple de connexions imposées pour l'entrelacement des symboles d'information non poinçonnés selon la première règle de connexion de la fonction d'entrelacement selon l'invention, selon l'exemple de réalisation de la figure 34,
- la figure 37 représente un autre exemple de masque de connexion pour les symboles d'information poinçonnés en fonction de leur degré de fragilité, selon l'exemple de réalisation de la figure 34,
- la figure 38 représente des courbes de taux d'erreur binaire sur canal gaussien du turbocode pour différentes configurations d'entrelacement, pour une longueur du message numérique d'entrée $K$ = 1504,
- la figure 39 représente des courbes de taux d'erreur trame sur canal gaussien du turbocode pour différentes configurations d'entrelacement, pour une longueur du message numérique d'entrée $K$ = 1504,
- la figure 40 représente des courbes de taux d'erreur binaire sur canal gaussien du turbocode pour différentes configurations d'entrelacement, pour une longueur du message numérique d'entrée $K$ = 6144, et
- la figure 41 représente des courbes de taux d'erreur trame sur canal gaussien du turbocode pour différentes configurations d'entrelacement, pour une longueur du message numérique d'entrée $K$ = 6144.

14

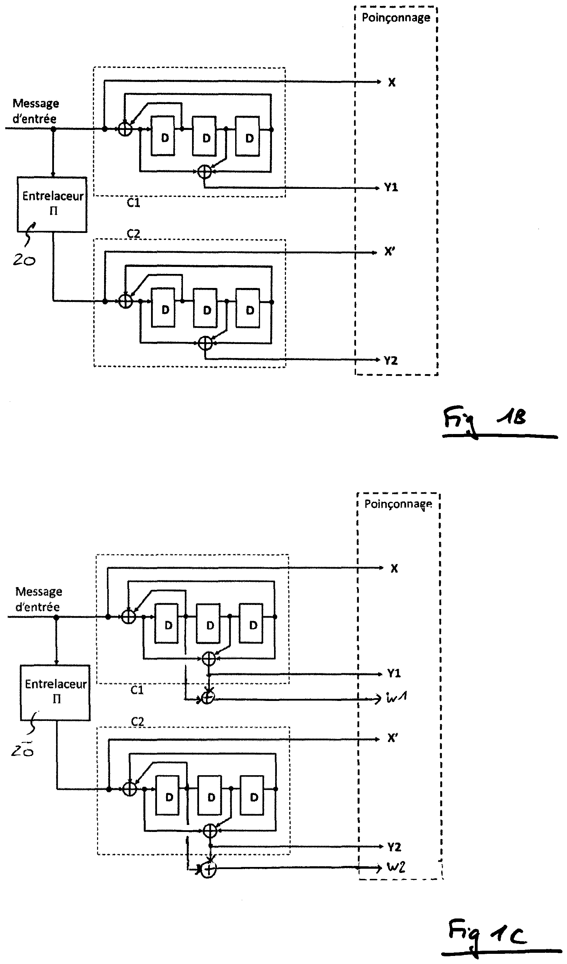

Les figures 1B et 1C illustrent la structure d'un turbo-encodeur selon l'invention, délivrant des symboles d'information (entrelacés ou non) et des symboles de redondance, et un poinçonnage des symboles d'information et/ou des symboles de redondance, respectivement pour un rendement de codage $R \geq 1/3$ et $1/3 > R \geq 1/5$.

Le turbo-encodeur illustré en figure 1B comprend un entrelaceur 20 et deux encodeurs, par exemple de type convolutifs systématiques récursifs (C1, C2), produisant chacun une sortie systématique (symboles d'information X dans l'ordre naturel pour le premier encodeur C1, ou symboles d'information X' dans l'ordre entrelacé pour le deuxième encodeur C2) et une sortie de redondance (symboles de redondance Y1 pour le premier encodeur C1, et symboles de redondance Y2 pour le deuxième encodeur C2). Le message numérique d'entrée, comprenant K symboles d'information, est encodé dans son ordre d'arrivée, dit ordre naturel, par l'encodeur C1, et dans l'ordre entrelacé, ou permuté, par l'encodeur C2.

Le message numérique de sortie, comprenant la sortie systématique (symboles d'information X ou bien symboles d'information X') et la sortie de redondance (symboles de redondance Y1 et Y2), peut être poinçonné suivant au moins un motif périodique de poinçonnage de longueur N. Par exemple, pour chaque rendement de codage supérieur à 1/3, trois motifs de poinçonnage de longueur N sont utilisés, exprimés par exemple chacun sous la forme d'un vecteur binaire : un premier motif de poinçonnage utilisé pour le poinçonnage des symboles d'information X ou X', un deuxième motif de poinçonnage utilisé pour le poinçonnage des symboles de redondance Y1, et un troisième motif de poinçonnage utilisé pour le poinçonnage des symboles de redondance Y2. Si les codes élémentaires des premier et deuxième encodeurs (C1, C2) du turbo-encodeur sont identiques, le même motif de poinçonnage peut être appliqué aux symboles de redondance Y1 et aux symboles de redondance Y2.

Le turbo-encodeur illustré en figure 1C comprend un entrelaceur 20 et deux encodeurs, par exemple de type convolutifs systématiques récursifs (C1, C2), produisant chacun une sortie systématique (symboles d'information X dans l'ordre naturel pour le premier encodeur C1, ou symboles d'information X' dans l'ordre entrelacé pour le deuxième encodeur C2) et deux sorties de redondance (symboles de redondance Y1 et W1 pour le premier encodeur C1, et symboles de redondance Y2 et W2 pour le deuxième encodeur C2). Le message numérique d'entrée, comprenant K symboles d'information, est encodé dans son ordre d'arrivée, dit ordre naturel, par l'encodeur C1, et dans l'ordre entrelacé, ou permuté, par l'encodeur C2.

Le message numérique de sortie, comprenant la sortie systématique (symboles d'information X ou bien symboles d'information X') et les deux sorties de redondance (symboles de redondance Y1 et W1 obtenus à partir du premier encodeur et symboles de redondance Y2 et W2 obtenus à partir du deuxième encodeur), peut être poinçonné suivant au moins un motif périodique de poinçonnage de longueur N. Par exemple, pour chaque rendement de codage compris entre 1/5 et 1/3, cinq motifs de poinçonnage de longueur N sont utilisés, exprimés par exemple chacun sous la forme d'un vecteur binaire : un premier motif de poinçonnage utilisé pour le poinçonnage des symboles d'information X ou X', un deuxième motif de poinçonnage utilisé pour le poinçonnage des symboles de redondance Y1, un troisième motif de poinçonnage utilisé pour le poinçonnage des symboles de redondance Y2, un quatrième motif de poinçonnage utilisé pour le poinçonnage des symboles de redondance W1, et un cinquième motif de poinçonnage utilisé pour le poinçonnage des symboles de redondance W2. Si les codes élémentaires des premier et deuxième encodeurs (C1, C2) du turbo-encodeur sont identiques, le même motif de poinçonnage peut être appliqué aux symboles de redondance Y1 et aux symboles de redondance Y2. De la même façon, le même motif de poinçonnage peut être appliqué aux symboles de redondance W1 et aux symboles de redondance W2.

D'autres rendements de codage peuvent bien entendu être obtenus avec un turbo-encodeur selon l'invention, en modifiant le nombre de sorties de redondance.

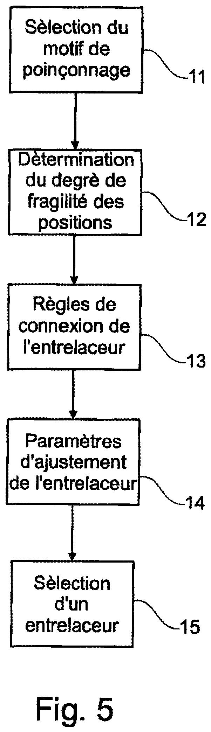

La figure 5 représente différentes étapes de mise en œuvre d'un procédé de construction d'un entrelaceur 20 pour un turbo-encodeur selon les figures 1B et 1C. Lors d'une étape 11, un motif de poinçonnage est préalablement sélectionné parmi une pluralité de motifs de poinçonnage, sur la base au moins d'une comparaison entre les spectres des distances des codes élémentaires poinçonnés correspondants et de mesures d'information mutuelle. Lors d'une étape 12, le degré de fragilité des différentes positions au sein du motif de poinçonnage sélectionné lors de l'étape 11 est déterminé. Lors d'une étape 13, une fonction d'entrelacement de l'entrelaceur est établie en connectant les positions selon au moins une règle de connexion de ladite fonction d'entrelacement, dépendante du degré de fragilité des positions. Lors d'une étape 14, un ensemble restreint de candidats est déterminé pour les paramètres d'ajustement $S(l)$ de la fonction d'entrelacement déterminée lors de l'étape 13. Lors d'une étape 15, au moins un entrelaceur 20 est sélectionné parmi l'ensemble restreint de candidats de l'étape 14, sur la base au moins des spectres des distances des turbocodes obtenus en utilisant les entrelaceurs correspondants.

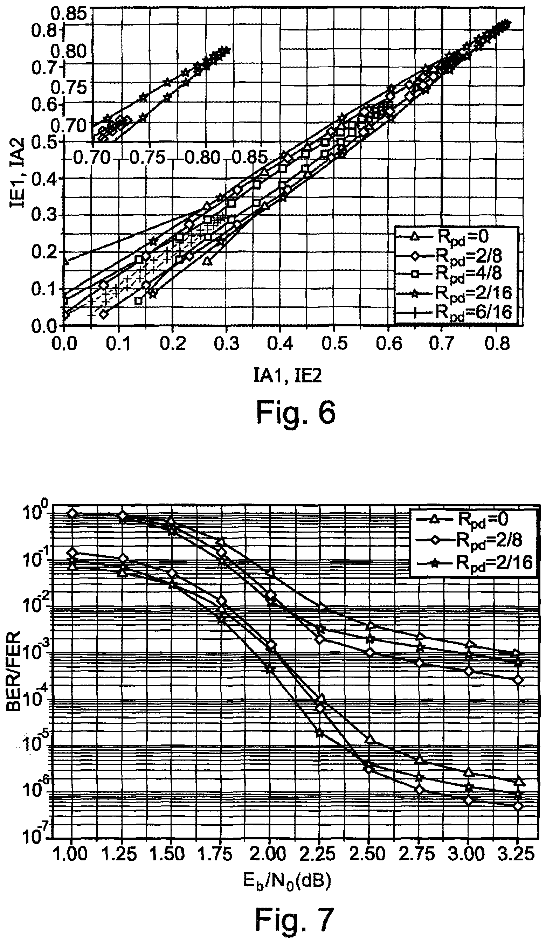

Un premier exemple de construction d'un entrelaceur 20 va être décrit en relation avec les figures 6, 7 et 18 à 22. Dans cet exemple, les codes élémentaires des premier et deuxième encodeurs C1, C2 du turbo-encodeur sont le code $CSR(13,15)_8$, dont le turbocode résultant a un rendement de codage $R = 2/3$, et la longueur du message numérique d'entrée est égale à $K = 1504$. La période de poinçonnage $N$, un diviseur de K, est égale à 16.

Le tableau ci-dessous liste les meilleurs motifs de poinçonnage en termes de spectre des distances du code élémentaire qui ont été obtenus pour $N = 16$. Les valeurs $A_d$ représentant la multiplicité $A_d$ à la distance $d = 0, 1, 2, 3,$

4. La valeur '1' correspond à un symbole non poinçonné, la valeur '0' à un symbole poinçonné. Le cas correspondant à $R_{pd}$ = 4/16 est plus simplement représentable à l'aide de $N$ = 8, soit $R_{pd}$ = 2/8, les symboles d'information / de redondance résultant étant 01111110/11000001. Les cas $R_{pd}$ = 0/16 et 8/16 ont plus simplement représentables à l'aide de $N$ = 4, soit $R_{pd}$ = 0/4 et 2/4, les symboles d'information / de redondance résultant étant 1111/1000 pour $R_{pd}$ = 0/4 et 1100/1001 pour $R_{pd}$ = 2/4.

| $R_{pd}$ | $R_c$ | $A_0$ | $A_1$ | $A_2$ | $A_3$ | $A_4$ | Motif de poinçonnage : symboles d'information / de redondance |
|---|---|---|---|---|---|---|---|
| 0/16 | 0.8 | 0 | 0 | 0 | 9 | 48 | 1111111111111111/1000100010001000 |
| 2/16 | 0.84 | 0 | 0 | 2 | 49 | 344 | 1111111110111011/0100000101001100 |
| 4/16 | 0.88 | 0 | 0 | 3 | 62 | 566 | 0111111001111110/1100000111000001 |
| 6/16 | 0.94 | 0 | 0 | 21 | 424 | 7490 | 1110101110101010/0001010001110101 |
| 8/16 | 1.0 | 0 | 4 | 38 | 358 | 3310 | 1100110011001100/1001100110011001 |
| 10/16 | 1.06 | 1 | 25 | 342 | 4804 | 66643 | 1110000010010100/1110100110110010 |

Le motif correspondant au ratio $R_{pd}$ = 10/16 et les valeurs supérieures ne sont pas admissibles, car conduisant à des motifs de poinçonnage catastrophiques où le rendement $R_c$ du code élémentaire, dépendant du nombre de symboles d'information poinçonnés et ainsi du ratio $R_{pd}$, est supérieur à 1.

Dans un second temps, on mesure l'information mutuelle échangée entre les décodeurs dans une structure de turbo-décodage à entrelacement uniforme pour les motifs de poinçonnages admissibles du tableau ci-dessus.

La figure 6 montre l'information mutuelle moyenne échangée entre les informations extrinsèques entrante et sortante de chaque décodeur élémentaire, pour $E_b/N_0$ = 1.6 dB, avec 16 itérations de turbo-décodage et un canal gaussien. La quantité d'information mutuelle échangée est d'autant plus grande que le point de jonction est proche du point de coordonnées (1,1). Dans l'exemple considéré, les deux motifs de poinçonnage correspondant aux ratios $R_{pd}$ de symboles d'information poinçonnés égaux à 2/16 et 2/8 sont sélectionnés, car les points de jonction des courbes sont plus proches du point (1,1) que le point de jonction des courbes correspondant à $R_{pd}$ = 0.

Dans l'exemple de la figure 7, les turbocodes à entrelaceur uniforme construits à partir des deux motifs de poinçonnage sélectionnés précédemment sont comparés en termes de performance dans les régions d'à-pic et d'évasement, en utilisant une modulation BPSK, « *binary phase-shift keying* » en anglais. Si le critère de performance retenu est le taux d'erreurs à fort rapport signal à bruit, dans la région d'évasement, plutôt qu'à faible et moyen rapport signal à bruit région d'à-pic, on privilégie le motif de poinçonnage correspondant à $R_{pd}$ = 2/8, avec des symboles d'information / de redondance résultant = 01111110/11000001. Dans le cas contraire, le motif de poinçonnage correspondant à $R_{pd}$ = 2/16 sera sélectionné.

Des règles de connexion de la fonction d'entrelacement sont ensuite choisies en fonction du motif de poinçonnage. Comme décrit précédemment, selon une règle connue, la fonction d'entrelacement doit transformer une position poinçonnée pour un symbole d'information dans l'ordre naturel en une position poinçonnée pour le symbole d'information entrelacé correspondant. Les connexions admissibles de l'entrelaceur pour les symboles d'information poinçonnés liées à cette règle sont illustrées à la figure 18, pour un motif de poinçonnage sélectionné correspondant à $R_{pd}$ = 2/8.

Comme décrit précédemment, on classe ensuite les positions des symboles d'information non poinçonnés par degré de fragilité, en poinçonnant chacun de ces symboles un par un et on effectue une détermination du spectre des distances du code élémentaire résultant dans chacun des cas. Le tableau ci-dessous donne les premiers termes des spectres des distances associés et le classement des positions en fonction de leur degré de fragilité, pour le motif de poinçonnage des redondances '11000001' correspondant à $R_{pd}$ = 2/8.

| $A_0$ | $A_1$ | $A_2$ | $A_3$ | $A_4$ | Motif de poinçonnage considéré | Classement par degré de fragilité croissante |
|---|---|---|---|---|---|---|
| 0 | 0 | 1880 | 1060320 | 465121494 | 00111110 | 1(position la moins fragile) |
| 0 | 0 | 4000 | 2003510 | 671273377 | 01011110 | 2 |

(suite)

| $A_0$ | $A_1$ | $A_2$ | $A_3$ | $A_4$ | Motif de poinçonnage considéré | Classement par degré de fragilité croissante |
|---|---|---|---|---|---|---|
| 0 | 4 | 3015 | 1151175 | 294778989 | 01101110 | 4 |
| 0 | 8 | 140 | 2229 | 35176 | 01110110 | 6 (position la plus fragile) |
| 0 | 2 | 2256 | 1275364 | 320347391 | 01111010 | 3 |
| 0 | 4 | 3019 | 1152688 | 148963135 | 01111100 | 5 |

La première règle de connexion consistant à connecter les positions les plus fragiles aux positions les moins fragiles, pour les symboles d'information non poinçonnés, par le biais de l'entrelaceur peut ensuite être appliquée sur toutes les positions considérées ou sur une partie seulement. A titre d'exemple, deux cas sont considérés ici.

Dans le premier cas, la position la plus fragile est connectée à la position la moins fragile. Aucune contrainte supplémentaire sur les positions des symboles d'information non poinçonnés n'est imposée pour la construction de l'entrelaceur. Cette règle aboutit à un masque de connexion pour les symboles d'information non poinçonnés représenté à la figure 19.

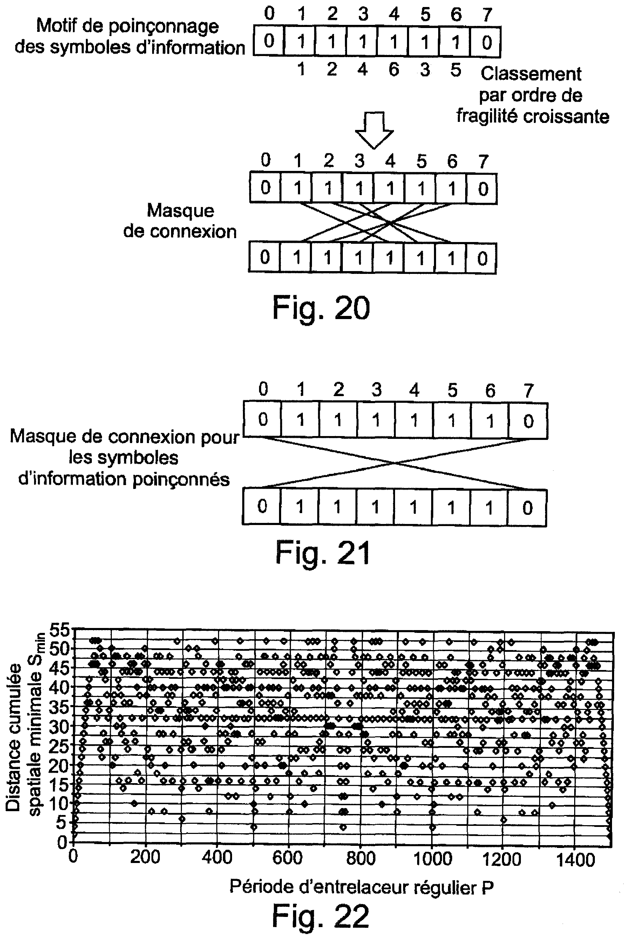

Dans le deuxième cas, une connexion croisée complète entre les positions est effectuée : la position la plus fragile est connectée à la position la moins fragile, la seconde position la plus fragile est connectée à la seconde position la moins fragile, et ainsi de suite. Cette règle aboutit à un masque de connexion pour les symboles d'information non poinçonnés représenté à la figure 20.

La deuxième règle de connexion consistant à connecter des positions de symboles d'information poinçonnés en fonction de leur degré de fragilité est ensuite appliquée. Dans l'exemple considéré, il n'y a que deux positions pour les symboles d'information poinçonnés, le masque de connexion en résultant est représenté à la figure 21.

On recherche ensuite un ensemble restreint de candidats pour les paramètres d'ajustement de la fonction d'entrelacement précédemment définie. La valeur maximale théorique de la distance cumulée spatiale minimale de l'entrelaceur pour un message d'entrée de longueur $K = 1504$ étant égale à 54, la valeur prédéfinie de la distance cumulée spatiale minimale $S_{min}$ peut être fixée à 80% de cette valeur, soit 44. La valeur prédéfinie de la longueur du cycle minimal de corrélation $G_{min}$ est fixée dans cet exemple à 8. Les valeurs admissibles pour la période d'entrelaceur $P$ sont les valeurs entières comprises entre 1 et 1503 premières avec 1504. La figure 22 montre les valeurs de la distance cumulée spatiale minimale $S_{min}$ correspondant à ces valeurs admissibles pour un entrelaceur régulier, dont la valeur maximale de la distance cumulée spatiale minimale est égale à 52.

Pour déterminer l'ensemble restreint de candidats pour les paramètres d'ajustement $S(I)$ pour chaque valeur de $P$ retenue, quatre cas ont été considérés. Le premier est le cas de référence où aucun symbole d'information n'est poinçonné, correspondant à $R_{pd} = 0$, appelé NDP, *« No Data Punctured »* en anglais. On utilise le motif de poinçonnage de la première ligne de la première table ci-dessus, où seules les redondances sont poinçonnées. Dans ce cas, aucun entrelaceur conférant au turbocode une distance de Hamming minimale supérieure à 15 n'a été trouvé.

Le deuxième cas correspond au cas où seule a été prise en compte la règle de connexion de l'entrelaceur selon laquelle la fonction d'entrelacement transforme la position poinçonnée d'un symbole d'information dans l'ordre naturel en une position poinçonnée pour le symbole d'information entrelacé correspondant, cas appelé DPC, *« Data Puncturing Constraint »* en anglais. Dans ce cas, sept entrelaceurs candidats à la distance 19 ont été trouvés.

Le troisième cas correspond au cas où la règle susmentionnée, le premier cas de la première règle et la deuxième règle de connexion ont été prises en compte, cas appelé DPPC1, *« Data and Parity Puncturing Constraint 1 »* en anglais. Dans ce cas, quatorze entrelaceurs candidats à la distance 19 ont été trouvés.

Le quatrième cas correspond au cas où la règle susmentionnée, le deuxième cas de la première règle et la deuxième règle de connexion ont été prises en compte, cas appelé DPPC2, *« Data and Parity Puncturing Constraint 2 »* en anglais. Dans ce cas, quarante entrelaceurs candidats à la distance 19 ont été trouvés, et un entrelaceur supplémentaire à la distance 20, avec des temps de recherche du même ordre de grandeur pour les quatre cas décrits.

Le tableau ci-dessous donne les quatre meilleurs entrelaceurs déterminés pour chaque cas, ainsi que les valeurs obtenues pour la distance cumulée spatiale minimale $S_{min}$ et la longueur du cycle minimal de corrélation $G_{min}$.

| Cas | $S_{min}$ | $G_{min}$ | $P$ | $S(0)$ | $S(1)$ | $S(2)$ | $S(3)$ | $S(4)$ | $S(5)$ | $S(6)$ | $S(7)$ |
|---|---|---|---|---|---|---|---|---|---|---|---|
| NDP | 45 | 8 | 399 | 0 | 792 | 630 | 829 | 1010 | 90 | 1471 | 658 |
| DPC | 45 | 8 | 227 | 0 | 495 | 998 | 280 | 1090 | 734 | 361 | 362 |
| DPPC1 | 45 | 8 | 699 | 0 | 289 | 1452 | 1292 | 1349 | 391 | 417 | 874 |

(suite)

| Cas | $S_{min}$ | $G_{min}$ | $P$ | $S(0)$ | $S(1)$ | $S(2)$ | $S(3)$ | $S(4)$ | $S(5)$ | $S(6)$ | $S(7)$ |
|------|-----------|-----------|-----|--------|--------|--------|--------|--------|--------|--------|--------|
| DPPC2 | 45 | 8 | 651 | 0 | 89 | 528 | 852 | 1501 | 1396 | 688 | 490 |

Les trois premiers termes du spectre des distances des turbocodes correspondants sont donnés dans le tableau ci-dessous. La valeur $w_{free}$ correspond au poids d'entrée cumulé des mots de code à la distance minimale de Hamming $d_o$.

| Cas | $W_{free}$ | $d_0$ | $d_1$ | $d_2$ | $A_{d_0}$ | $A_{d_1}$ | $A_{d_2}$ |
|------|-----------|-------|-------|-------|-----------|-----------|-----------|
| NDP | 5640 | 15 | 16 | 17 | 1128 | 4512 | 7708 |
| DPC | 4324 | 19 | 20 | 21 | 752 | 1880 | 5264 |
| DPPC1 | 2444 | 19 | 20 | 21 | 376 | 2444 | 3572 |
| DPPC2 | 10716 | 20 | 21 | 22 | 1504 | 3008 | 6016 |

Dans cet exemple, le poinçonnage des symboles d'information permet d'augmenter la distance minimale de Hamming du turbocode. L'application de la première règle de connexion sous forme partielle et de la deuxième règle, correspondant au cas DPPC1, ne permet pas dans ce cas une augmentation de distance par rapport aux codes DPC connus, même si le nombre des mots de codes à la distance minimale $d_0$ est plus faible. En revanche, l'application de la première règle de connexion sous forme complète et de la deuxième règle, correspondant au cas DPPC2, permet de gagner un point de distance par rapport aux codes DPC connus pour lesquels est seule prise en compte la règle selon laquelle la fonction d'entrelacement transforme la position poinçonnée d'un symbole d'information dans l'ordre naturel en une position poinçonnée pour le symbole d'information entrelacé correspondant.

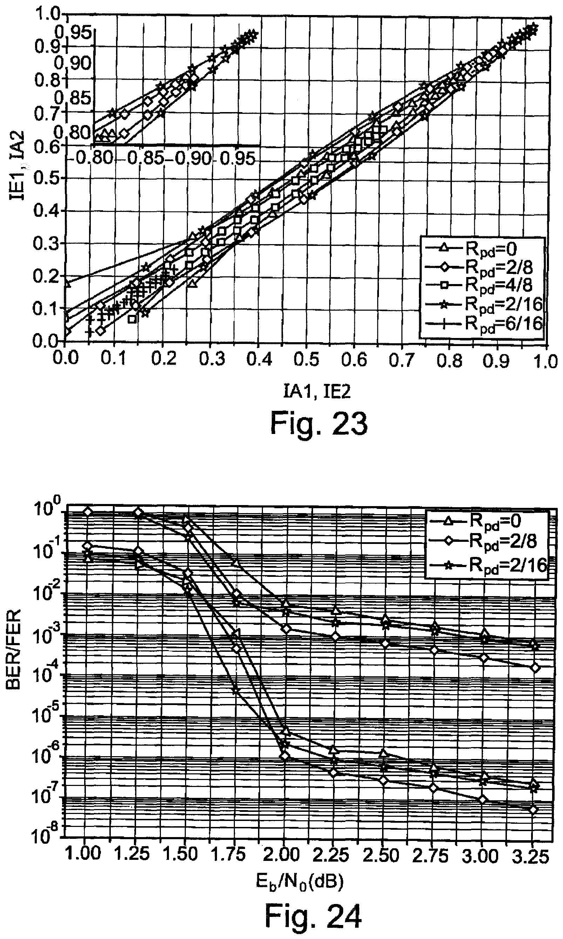

Un deuxième exemple de construction d'un entrelaceur 20 est décrit en relation avec les figures 23 à 25. Cet exemple diffère de l'exemple précédent en ce que la longueur du message numérique d'entrée est égale à $K = 6144$.

Le spectre des distances du code élémentaire ne dépendant pas de la valeur de la longueur $K$ du message numérique d'entrée, les motifs de poinçonnage sélectionnés pour l'exemple précédent sont également valables.

La figure 23 montre l'information mutuelle moyenne échangée entre les informations extrinsèques entrante et sortante de chaque décodeur élémentaire. Les conclusions sont similaires à celle obtenues pour $K = 1504$ : les motifs sélectionnés selon ce critère correspondent aux ratios $R_{pd}$ de symboles d'information poinçonnés égaux à 2/16 et 2/8.

La figure 24 montre les courbes de taux d'erreurs des turbocodes à entrelacement uniforme construits à partir des trois motifs de poinçonnage sélectionnés à l'étape précédente. La conclusion est également identique à celle de l'exemple précédent : dans le cas où des taux d'erreurs faibles sont recherchés, notamment pour FER<$10^{-6}$, est privilégié le motif de poinçonnage correspondant à $R_{pd} = 2/8$, les symboles d'information / de redondance résultant étant 01111110/11000001.

Le motif de poinçonnage sélectionné étant le même que dans l'exemple précédent, le choix des règles de connexion de la fonction d'entrelacement liées au poinçonnage peut directement réutiliser les résultats précédemment obtenus.

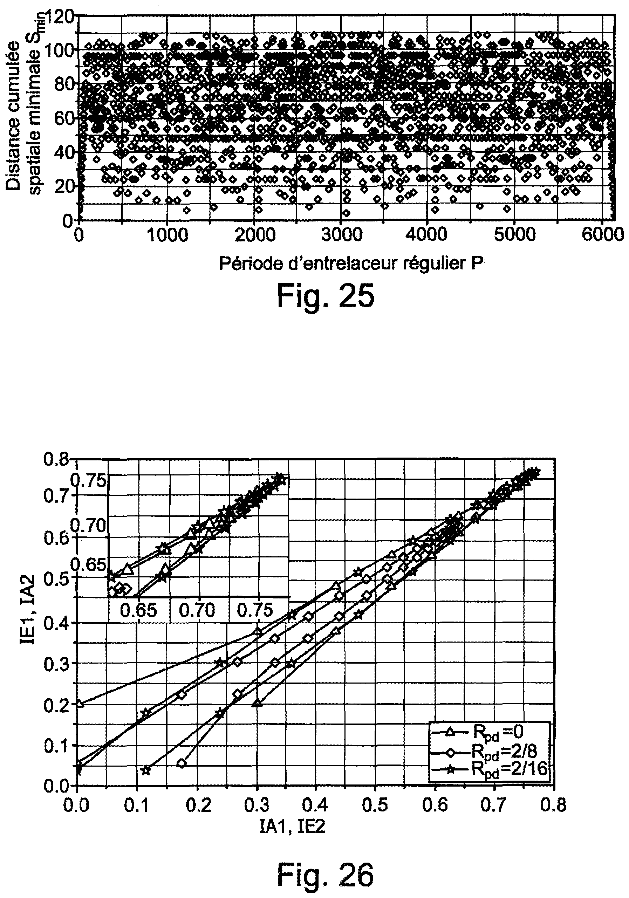

On recherche ensuite un ensemble restreint de candidats pour les paramètres d'ajustement de la fonction d'entrelacement précédemment définie. La valeur maximale théorique de la distance cumulée spatiale minimale de l'entrelaceur pour un message d'entrée de longueur $K = 6144$ étant égale à 110, la valeur prédéfinie de la distance cumulée spatiale minimale $S_{min}$ peut être fixée à 65 % de cette valeur, soit 75. La valeur prédéfinie de la longueur du cycle minimal de corrélation $G_{min}$ est fixée dans cet exemple à 8. Les valeurs admissibles pour la période d'entrelaceur $P$ sont les valeurs entières comprises entre 1 et 6143 premières avec 6144. La figure 25 montre les valeurs de la distance cumulée spatiale minimale $S_{min}$ correspondant à ces valeurs admissibles pour un entrelaceur régulier.

Pour déterminer l'ensemble restreint de candidats pour les paramètres d'ajustement $S(I)$ pour chaque valeur de $P$ retenue, seuls les trois premiers cas précédemment décrits ont été considérés, à savoir les cas NDP, DPC et DPPC1.

Dans le cas NDP, aucun entrelaceur conférant au turbocode une distance de Hamming minimale supérieure à 16 n'a été trouvé. Dans le cas DPC, six entrelaceurs candidats à la distance 22 ont été trouvés, et dans le cas DPPC1, soixante-dix-huit entrelaceurs candidats à la distance 22, pour des temps de recherche du même ordre de grandeur.

Le tableau ci-dessous donne les quatre meilleurs entrelaceurs déterminés pour chaque cas, ainsi que les valeurs obtenues pour la distance cumulée spatiale minimale $S_{min}$ et la longueur du cycle minimal de corrélation $G_{min}$.

| Cas | $S_{min}$ | $G_{min}$ | $P$ | $S(0)$ | $S(1)$ | $S(2)$ | $S(3)$ | $S(4)$ | $S(5)$ | $S(6)$ | $S(7)$ |
|---|---|---|---|---|---|---|---|---|---|---|---|
| NDP | 75 | 9 | 83 | 0 | 3340 | 732 | 2196 | 2877 | 391 | 481 | 4095 |
| DPC | 77 | 8 | 1045 | 0 | 727 | 3195 | 2775 | 4053 | 361 | 4517 | 1652 |
| DPPC1 | 75 | 8 | 3773 | 0 | 4647 | 691 | 511 | 3541 | 6009 | 1773 | 900 |

Les trois premiers termes du spectre des distances des turbocodes correspondants sont donnés dans le tableau ci-dessous.

| Cas | $W_{free}$ | $d_0$ | $d_1$ | $d_2$ | $A_{d_0}$ | $A_{d_1}$ | $A_{d_2}$ |
|---|---|---|---|---|---|---|---|
| NDP | 30720 | 16 | 17 | 18 | 4608 | 6912 | 16128 |
| DPC | 77568 | 22 | 23 | 24 | 12288 | 7680 | 24756 |
| DPPC1 | 67584 | 22 | 23 | 24 | 10752 | 6144 | 19968 |

Dans cet exemple également, le poinçonnage des symboles d'information permet d'augmenter la distance minimale de Hamming du turbocode. L'application de la première règle de connexion sous forme partielle et de la deuxième règle, correspondant au cas DPPC1, ne permet pas dans ce cas une augmentation de distance par rapport aux codes DPC connus, même si le nombre des mots de codes à la distance minimale $d_0$ est plus faible, mais elle permet au processus de recherche d'être plus efficace et de produire plus de bons jeux de paramètres.

Un troisième exemple de construction d'un entrelaceur 20 est décrit en relation avec les figures 26 à 31. Cet exemple diffère de l'exemple précédent en ce que le rendement de codage est égal à $R = 4/5$ et la longueur du message numérique d'entrée est égale à $K = 1504$.

Le tableau ci-dessous liste les meilleurs motifs de poinçonnage en termes de spectre des distances du code élémentaire qui ont été obtenus pour $N = 16$. Le cas correspondant à $R_{pd} = 0/16$ est plus simplement représentable à l'aide de N = 8, soit $R_{pd} = 0/8$, les symboles d'information / de redondance résultant étant 11111111/01000000. Le cas $R_{pd} = 4/16$ est plus simplement représentable à l'aide de N = 4, soit $R_{pd} = 1/4$, les symboles d'information / de redondance résultant étant 1110/1000.

| $R_{pd}$ | $R_c$ | $A_0$ | $A_1$ | $A_2$ | $A_3$ | $A_4$ | Motif de poinçonnage : symboles d'information /redondances |
|---|---|---|---|---|---|---|---|
| 0/16 | 0.88 | 0 | 0 | 4 | 72 | 645 | 1111111111111111/0100000001000000 |
| 2/16 | 0.94 | 0 | 0 | 24 | 525 | 8732 | 0111111111111101/1100000000000010 |
| 4/16 | 1.0 | 0 | 4 | 42 | 424 | 4204 | 1110111011101110/1000100010001000 |
| 6/16 | 1.06 | 1 | 25 | 379 | 5412 | 77412 | 1111001110110001/0001011100100000 |

Les motifs correspondant au ratio $R_{pd} = 6/16$ et aux valeurs supérieures ne sont pas admissibles, car conduisant à des motifs de poinçonnage catastrophiques où le rendement $R_c$ du code élémentaire est supérieur à 1.

Dans un second temps, on mesure l'information mutuelle échangée entre les décodeurs dans une structure de turbo-décodage à entrelacement uniforme pour les motifs de poinçonnages admissibles du tableau ci-dessus. La figure 26 montre l'information mutuelle moyenne échangée entre les informations extrinsèques entrante et sortante de chaque décodeur élémentaire, pour $E_b/N_0 = 2,55$ dB, avec 16 itérations de turbo-décodage et un canal gaussien. Dans l'exemple considéré, le seul motif de poinçonnage correspondant au ratio $R_{pd}$ de symboles d'information poinçonnés égal à 2/16 est sélectionné, car les points de jonction des courbes sont plus proches du point (1,1) que le point de jonction des courbes correspondant à $R_{pd} = 0$.

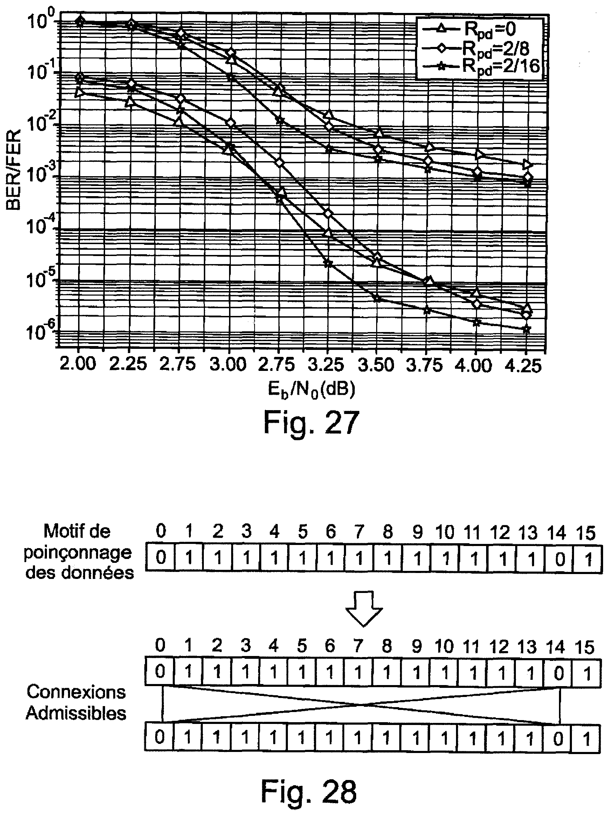

Les turbocodes à entrelaceur uniforme construits à partir des motifs de poinçonnage envisagés précédemment sont comparés en termes de performance dans les régions d'à-pic et d'évasement, comme représenté à la figure 27. Ces résultats confirment le choix du motif de poinçonnage correspondant à $R_{pd} = 2/16$, avec des symboles d'information / de redondance résultant = 0111111111111101/1100000000000010.

Pour l'exemple considéré, les connexions admissibles de l'entrelaceur pour les symboles d'information poinçonnés liées à la règle selon laquelle la fonction d'entrelacement doit transformer une position poinçonnée pour un symbole d'information dans l'ordre naturel en une position poinçonnée pour le symbole d'information entrelacé correspondant sont illustrées à la figure 28.

Comme décrit précédemment, on classe ensuite les positions des symboles d'information non poinçonnés par degré de fragilité, et on effectue une détermination du spectre des distances du code élémentaire résultant dans chacun des cas. Le tableau ci-dessous donne les premiers termes des spectres des distances associés et le classement des positions en fonction de leur degré de fragilité, pour le motif de poinçonnage sélectionné correspondant à $R_{pd}$ = 2/16.

| Numéro de la position | $A_0$ | $A_1$ | $A_2$ | $A_3$ | $A_4$ | Motif de poinçonnage des symboles d'information sélectionné | Classement par degré de fragilité croissante | Classement simplifié |
|---|---|---|---|---|---|---|---|---|
| 1 | 0 | 0 | 3503 | 2200764 | 946127360 | 0011111111111101 | 1 (position la moins fragile) | 1 |
| 2 | 0 | 2 | 6371 | 3140138 | 1138244658 | 0101111111111101 | 4 | 2 |
| 3 | 0 | 16 | 491 | 13686 | 376258 | 0110111111111101 | 12 | 4 |
| 4 | 0 | 8 | 6047 | 2331934 | 606872251 | 0111011111111101 | 9 | 3 |
| 5 | 0 | 8 | 6032 | 2327999 | 527349550 | 0111101111111101 | 6 | 3 |
| 6 | 0 | 2 | 6125 | 3274279 | 996842927 | 0111110111111101 | 3 | 2 |
| 7 | 0 | 16 | 536 | 16292 | 359330 | 0011111011111101 | 13 | 5 |
| 8 | 0 | 16 | 489 | 13457 | 113075 | 0111111101111101 | 11 | 4 |
| 9 | 0 | 2 | 6376 | 3144441 | 735019476 | 0111111110111101 | 5 | 2 |
| 10 | 0 | 16 | 536 | 16307 | 68224 | 0111111111011101 | 14 (position la plus fragile) | 5 |
| 11 | 0 | 8 | 6038 | 2332485 | 160321914 | 0111111111101101 | 7 | 3 |
| 12 | 0 | 8 | 6042 | 2328199 | 377642859 | 0111111111110101 | 8 | 3 |
| 13 | 0 | 2 | 6123 | 3272599 | 750308910 | 0111111111111001 | 2 | 2 |
| 15 | 0 | 8 | 6047 | 2334859 | 381315178 | 0111111111111100 | 10 | 3 |

Dans cet exemple, la position n°10 est considérée comme étant la plus fragile. La position n°7 présente un niveau de fragilité similaire et pourrait aussi être retenue. De même, dans cet exemple, plusieurs groupes de positions ont des degrés de fragilités très proches : c'est le cas par exemple des positions n°2, n°6, n°9 et n°13 d'une part et n°4, n°5, n°11, n°12 et n°14, d'autre part. Lorsque les positions n°2, n°6, n°9 ou n°13 sont poinçonnées, le premier terme de multiplicité est identique et égal à 2 tandis que les seconds termes sont proches, compris entre 6123 et 6176. De même, lorsque les positions n°4, n°5, n°11, n°12 ou n°14 sont poinçonnées, le premier terme de multiplicité est identique et égal à 8 tandis que les seconds termes sont proches, compris entre 6032 et 6047. Le choix de l'une ou l'autre de ces positions au sein du même groupe lors du processus de classement n'a par conséquent qu'un très faible impact sur les performances des entrelaceurs résultants. On peut leur attribuer le même degré de fiabilité, comme représenté dans la colonne « classement simplifié » du tableau ci-dessus.

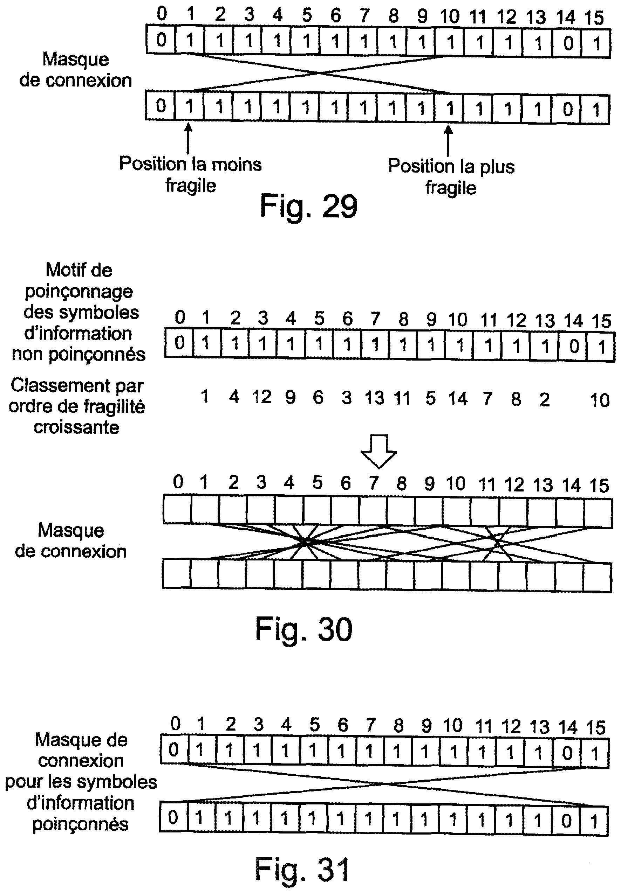

Comme précédemment, le premier cas de la première règle de connexion est appliqué, la position la plus fragile étant connectée à la position la moins fragile, aboutissant à un masque de connexion pour les symboles d'information non poinçonnés représenté à la figure 29.

Le deuxième cas décrit précédemment est également appliqué : une connexion croisée complète entre les positions est effectuée, aboutissant à un masque de connexion pour les symboles d'information non poinçonnés représenté à la figure 30.

La deuxième règle de connexion consistant à connecter des positions de symboles d'information poinçonnés en fonction de leur degré de fragilité est ensuite appliquée. Dans l'exemple considéré, il n'y a que deux positions pour les symboles d'information poinçonnés, le masque de connexion en résultant est représenté à la figure 31.

On recherche ensuite un ensemble restreint de candidats pour les paramètres d'ajustement de la fonction d'entrelacement précédemment définie. Dans l'exemple considéré, la valeur prédéfinie de la distance cumulée spatiale minimale $S_{min}$ est fixée à 70% de sa valeur théorique maximale pour $K = 1504$, soit 39. La valeur prédéfinie de la longueur du cycle minimal de corrélation $G_{min}$ est fixée dans cet exemple à 8.

Pour déterminer l'ensemble restreint de candidats pour les paramètres d'ajustement $S(I)$ pour chaque valeur de P retenue, les quatre cas NDP, DPC, DPPC1 et DPPC2 précédemment décrits ont été considérés.

Dans le cas NDP, aucun entrelaceur conférant au turbocode une distance de Hamming minimale supérieure à 9 n'a été trouvé. Dans le cas DPC, deux entrelaceurs candidats à la distance 11 ont été trouvés, dans le cas DPPC1, six entrelaceurs candidats à la distance 11, et dans le cas DPPC2, vingt-trois entrelaceurs candidats à la distance 11.

Le tableau ci-dessous donne les quatre meilleurs entrelaceurs déterminés pour chaque cas, ainsi que les valeurs obtenues pour la distance cumulée spatiale minimale $S_{min}$ et la longueur du cycle minimal de corrélation $G_{min}$.

| Cas | $S_{min}$ | $G_{min}$ | $P$ | $(S(0) ... S(15))$ |
|---|---|---|---|---|
| NDP | 39 | 8 | 725 | (0, 250, 1224, 239, 931, 48, 236, 449, 30, 856, 1487, 1228, 1440, 1372, 293, 93) |
| DPC | 39 | 8 | 267 | (0, 1436, 521, 1492, 1048, 1142, 1337, 957, 57, 1125, 740, 189, 56, 650, 852, 158) |
| DPPC1 | 39 | 8 | 583 | (0, 1107, 1412, 1038, 909, 1250, 546, 1366, 958, 1445, 299, 178, 1273, 96, 1212, 1487) |
| DPPC2 | 39 | 8 | 365 | (0, 1261, 1374, 1279, 417, 867, 549, 514, 730, 474, 1359, 285, 927, 670, 1176, 1078) |

Les trois premiers termes du spectre des distances des turbocodes correspondants sont donnés dans le tableau ci-dessous.

| Cas | $W_{free}$ | $d_0$ | $d_1$ | $d_2$ | $A_{d_0}$ | $A_{d_1}$ | $A_{d_2}$ |
|---|---|---|---|---|---|---|---|
| NDP | 12220 | 9 | 10 | 11 | 2350 | 8554 | 29516 |
| DPC | 10434 | 11 | 12 | 13 | 1880 | 5358 | 16732 |
| DPPC1 | 4888 | 11 | 12 | 13 | 940 | 4606 | 12878 |
| DPPC2 | 4324 | 11 | 12 | 13 | 752 | 4794 | 15134 |

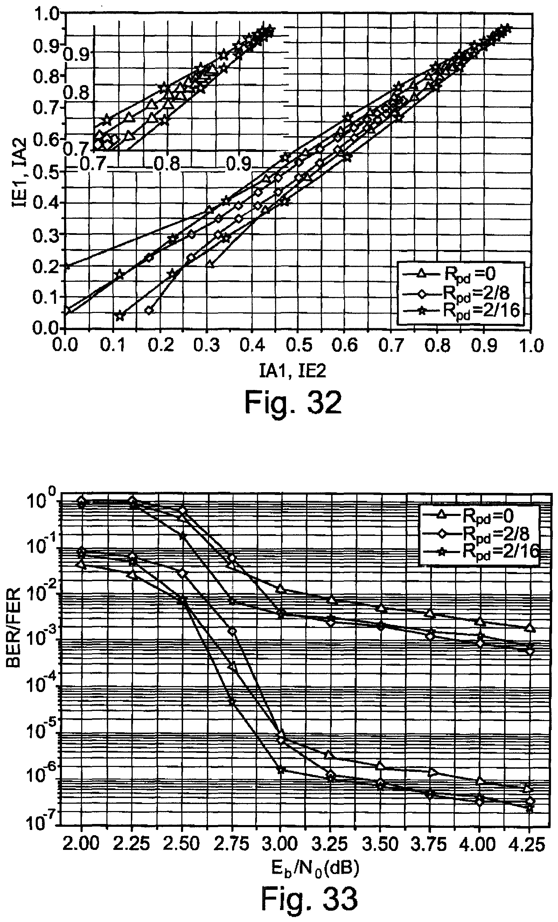

Un quatrième exemple de construction d'un entrelaceur 20 est décrit en relation avec les figures 32 et 33. Cet exemple diffère de l'exemple précédent en ce que la longueur du message numérique d'entrée est égale à $K = 6144$.

Le spectre des distances du code élémentaire ne dépendant pas de la valeur de la longueur $K$ du message numérique d'entrée, les motifs de poinçonnage sélectionnés pour l'exemple précédent sont également valables.

La figure 32 montre l'information mutuelle moyenne échangée entre les informations extrinsèques entrante et sortante de chaque décodeur élémentaire. Le motif sélectionné selon ce critère correspond au ratio $R_{pd}$ de symboles d'information poinçonnés égal à 2/16.

Les turbocodes à entrelaceur uniforme construits à partir des motifs de poinçonnage envisagés précédemment sont comparés en termes de performance dans les régions d'à-pic et d'évasement, comme représenté à la figure 33. Ces résultats confirment le choix du motif de poinçonnage correspondant à $R_{pd} = 2/16$, avec des symboles d'information / de redondance résultant = 0111111111111101/1100000000000010.

Le motif de poinçonnage sélectionné étant le même que dans l'exemple précédent, le choix des règles de connexion de la fonction d'entrelacement liées au poinçonnage peut directement réutiliser les résultats précédemment obtenus.

On recherche ensuite un ensemble restreint de candidats pour les paramètres d'ajustement de la fonction d'entrelacement précédemment définie. Dans l'exemple considéré, la valeur prédéfinie de la distance cumulée spatiale minimale $S_{min}$ est fixée à 70% de sa valeur théorique maximale pour $K = 6144$, soit 80. La valeur prédéfinie de la longueur du cycle minimal de corrélation $G_{min}$ est fixée dans cet exemple à 8.

Pour déterminer l'ensemble restreint de candidats pour les paramètres d'ajustement $S(I)$ pour chaque valeur de P retenue, seuls les trois premiers cas précédemment décrits ont été considérés, à savoir les cas NDP, DPC et DPPC1.

Dans le cas NDP, aucun entrelaceur conférant au turbocode une distance de Hamming minimale supérieure à 10 n'a été trouvé. Dans le cas DPC, deux-cent quarante-neuf entrelaceurs candidats à la distance 12 ont été trouvés, et dans le cas DPPC1, quatre-cent quatre-vingt-dix-neuf entrelaceurs candidats à la distance 12, et huit entrelaceurs candidats à la distance 13.

Le tableau ci-dessous donne les quatre meilleurs entrelaceurs déterminés pour chaque cas, ainsi que les valeurs obtenues pour la distance cumulée spatiale minimale $S_{min}$ et la longueur du cycle minimal de corrélation $G_{min}$.

| Cas | $S_{min}$ | $G_{min}$ | $P$ | $(S(0) \dots S(15))$ |
|---|---|---|---|---|
| NDP | 80 | 8 | 4741 | (0, 3987, 2144, 4792, 5501, 3772, 3569, 5513, 1966, 4855, 3369, 3527, 349, 6130, 2295, 807) |
| DPC | 80 | 8 | 3607 | (0, 5579, 1681, 1714, 12, 3337, 140, 586, 1353, 3509, 879, 774, 4117, 850, 876, 5393) |
| DPPC1 | 80 | 8 | 953 | (0, 801, 3826, 5118, 210, 1698, 6065, 684, 5076, 2695, 4119, 5250, 775, 3768, 624, 11) |

Les trois premiers termes du spectre des distances des turbocodes correspondants sont donnés dans le tableau ci-dessous.

| Cas | $W_{free}$ | $d_0$ | $d_1$ | $d_2$ | $A_{d_0}$ | $A_{d_1}$ | $A_{d_2}$ |
|---|---|---|---|---|---|---|---|
| NDP | 1536 | 10 | 11 | 12 | 384 | 3840 | 25728 |
| DPC | 5376 | 12 | 13 | 14 | 768 | 7680 | 15360 |
| DPPC1 | 14208 | 13 | 14 | 15 | 2304 | 5760 | 28032 |

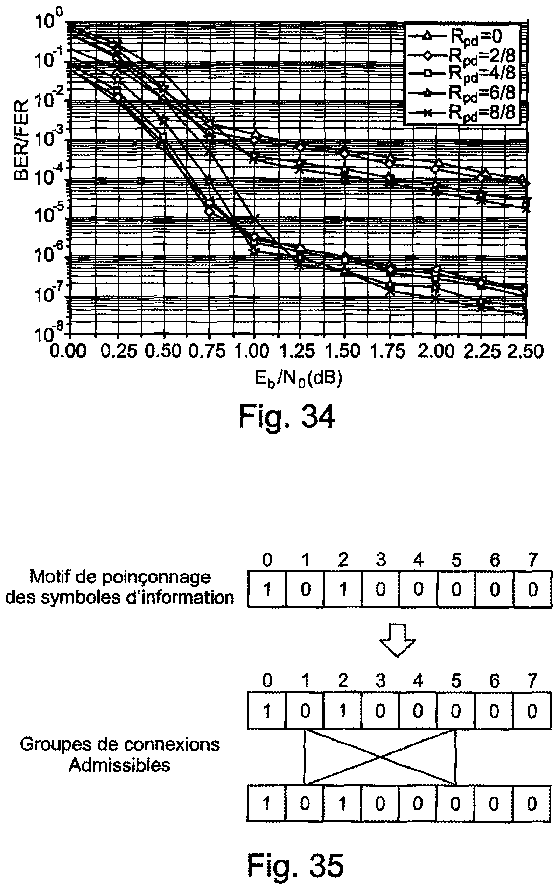

Un cinquième exemple de construction d'un entrelaceur 20 est décrit en relation avec les figures 34 à 37. Cet exemple diffère des exemples précédents en ce que les codes élémentaires des premier et deuxième encodeurs C1, C2 du turbo-encodeur sont le code $CSR(13,15,17)_8$, le rendement de codage étant égal à $R = 1/3$ et la longueur du message numérique d'entrée étant égale à $K = 1504$.

Le tableau ci-dessous liste les meilleurs motifs de poinçonnage en termes de spectre des distances du code élémentaire qui ont été obtenus pour la période de poinçonnage $N = 8$.

| $R_{pd}$ | $R_c$ | $A_4$ | $A_5$ | $A_6$ | $A_7$ | $A_8$ | $A_9$ | $A_{10}$ | Motif de poinçonnage : symboles d'information /redondances1/ redondances2 |
|---|---|---|---|---|---|---|---|---|---|
| 0/8 | 0.5 | 0 | 0 | 2 | 0 | 10 | 0 | 49 | 11111111 / 11111111 / 00000000 |
| 2/8 | 0.53 | 0 | 3 | 20 | 33 | 83 | 202 | 311 | 11101110 / 10110000 / 01011111 |
| 4/8 | 0.57 | 0 | 6 | 12 | 35 | 90 | 223 | 479 | 10101010 / 11111111 / 01000100 |
| 6/8 | 0.62 | 2 | 26 | 66 | 165 | 500 | 1526 | 2845 | 10100000 / 11101111 / 01011010 |
| 8/8 | 0.66 | 3 | 11 | 35 | 114 | 378 | 1253 | 4147 | 00000000 / 11111111 / 10101010 |

Toutes les valeurs du ratio $R_{pd}$ sont admissibles, car conduisant à des valeurs du rendement $R_c$ du code élémentaire inférieures à 1.

Les turbocodes à entrelaceur uniforme construits à partir des motifs de poinçonnage du tableau ci-dessus sont comparés en termes de performance dans les régions d'à-pic et d'évasement, comme représenté à la figure 34. Le motif de poinçonnage correspondant à $R_{pd} = 6/8$ avec des symboles d'information / de redondance résultant = 10100000 / 11101111 / 01011010 est retenu.

Pour l'exemple considéré, les connexions admissibles de l'entrelaceur pour les symboles d'information poinçonnés liées à la règle selon laquelle la fonction d'entrelacement doit transformer une position poinçonnée pour un symbole d'information dans l'ordre naturel en une position poinçonnée pour le symbole d'information entrelacé correspondant sont illustrées à la figure 35.

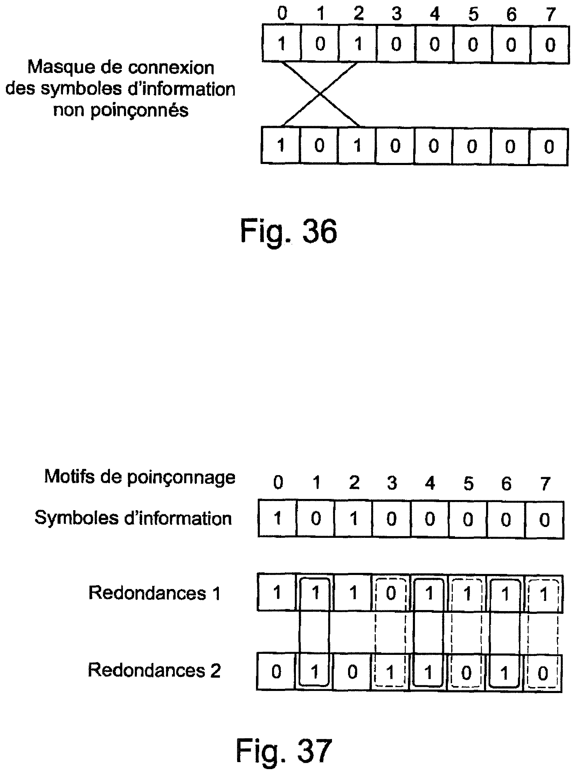

Comme décrit précédemment, la première règle de connexion consistant à connecter des positions de symboles d'information non poinçonnés en fonction de leur degré de fragilité est ensuite appliquée. Dans l'exemple considéré, il n'y a que deux positions pour les symboles d'information non poinçonnés, le masque de connexion en résultant est représenté à la figure 36.

La deuxième règle de connexion consistant à connecter des positions de symboles d'information poinçonnés en fonction de leur degré de fragilité est ensuite appliquée. Dans l'exemple considéré, la figure 37 illustre la détermination de deux degrés de fragilité des positions en fonction du nombre de symboles de redondance poinçonnés : les positions repérées en traits pointillés, correspondant à un symbole de redondance poinçonné, sont plus fragiles que les positions repérées en traits pleins, correspondant à aucun symbole de redondance poinçonné. Selon cette règle, on connectera chacune des positions n°1, 4 et 6 à l'une des positions n°3, 5 et 7.

On recherche ensuite un ensemble restreint de candidats pour les paramètres d'ajustement de la fonction d'entrelacement précédemment définie. Dans l'exemple considéré, la valeur prédéfinie de la distance cumulée spatiale minimale $S_{min}$ est fixée à 80% de sa valeur théorique maximale pour $K = 1504$, soit 44. La valeur prédéfinie de la longueur du cycle minimal de corrélation $G_{min}$ est fixée dans cet exemple à 8.

Pour déterminer l'ensemble restreint de candidats pour les paramètres d'ajustement $S(l)$ pour chaque valeur de P retenue, les trois cas NDP, DPC et DPPC1 précédemment décrits ont été considérés. Le cas DPPC1 correspond au cas où la première règle et la deuxième règle de connexion telles que décrites ci-dessus ont été appliquées.

Dans le cas NDP, aucun entrelaceur conférant au turbocode une distance de Hamming minimale supérieure à 49 n'a été trouvé. Dans le cas DPC, deux entrelaceurs candidats à la distance 59 ont été trouvés, et dans le cas DPPC1, un entrelaceur candidat à la distance 61.

Le tableau ci-dessous donne les meilleurs entrelaceurs déterminés pour chaque cas, ainsi que les valeurs obtenues pour la distance cumulée spatiale minimale $S_{min}$ et la longueur du cycle minimal de corrélation $G_{min}$.

| Cas | $S_{min}$ | $G_{min}$ | $P$ | $S(0)$ | $S(1)$ | $S(2)$ | $S(3)$ | $S(4)$ | $S(5)$ | $S(6)$ | $S(7)$ |
|---|---|---|---|---|---|---|---|---|---|---|---|
| NDP | 47 | 8 | 59 | 0 | 619 | 1198 | 1496 | 1209 | 1260 | 917 | 973 |
| DPC | 45 | 8 | 1219 | 0 | 938 | 732 | 1427 | 739 | 378 | 449 | 1297 |
| DPPC1 | 45 | 8 | 487 | 2 | 462 | 106 | 191 | 131 | 342 | 601 | 1197 |

Les trois premiers termes du spectre des distances des turbocodes correspondants sont donnés dans le tableau ci-dessous.

| Cas | $W_{free}$ | $d_0$ | $d_1$ | $d_2$ | $A_{d_0}$ | $A_{d_1}$ | $A_{d_2}$ |
|---|---|---|---|---|---|---|---|
| NDP | 2632 | 49 | 50 | 51 | 376 | 564 | 940 |
| DPC | 752 | 59 | 60 | 61 | 188 | 376 | 376 |
| DPPC1 | 3196 | 61 | 62 | 63 | 376 | 376 | 564 |

Un entrelaceur ainsi construit peut alors être utilisé dans un turbo-encodeur selon l'invention. En particulier, comme déjà indiqué, un tel entrelaceur répartit les symboles d'information du message d'entrée dans $Q$ couches du message d'entrée entrelacé en respectant la fonction d'entrelacement définie à partir du ou des motifs de poinçonnage, selon la relation :

$$\pi(i) = Pi + S(i \bmod Q) \bmod K = Pi + S(l) \bmod K = Pi + (T_l + A_l Q) \bmod K$$

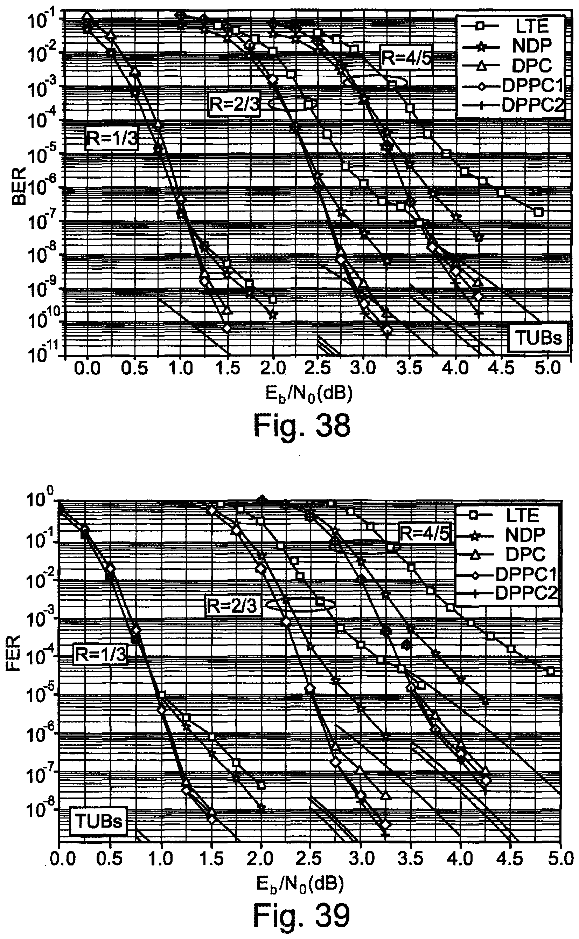

Les figures 38 à 41 montrent les performances en termes de taux d'erreur binaire BER et de taux d'erreur trame FER des turbocodes poinçonnés utilisant les différentes configurations d'entrelacement proposées. Des gains significatifs sont obtenus par rapport au turbocode LTE qui utilise un entrelacement QPP et la technique de poinçonnage dite « *rate matching* ».

La figure 38 représente des courbes de taux d'erreur binaire du turbocode pour différentes configurations d'entrelacement, pour différents rendements de codage $R$, avec un canal gaussien, une modulation BPSK, une longueur du message numérique d'entrée égale à $K = 1504$, et 16 itérations de décodage utilisant l'algorithme BCJR « Bahl-Cocke-Jelinek-Raviv ». L'indication « TUB » désigne la borne de l'union tronquée, correspondant aux premiers termes de la borne de l'union appliquée à la probabilité d'erreur par paire. La borne de l'union, aussi appelée inégalité de Boole, définit la probabilité d'occurrence d'un évènement quelconque pris dans un ensemble d'événements discrets, et est inférieure ou égale à la somme des probabilités de chacun des évènements pris séparément. La probabilité d'erreur par paire P(x,x') correspond à la probabilité que le décodeur décode le mot de code x' alors que le mot de code x a été transmis. La borne de l'union permet d'obtenir une borne inférieure de la probabilité que le décodeur se trompe lorsque le mot de code x a été transmis : Pe (x) ≤Σx' P(x, x'). Pour obtenir la TUB, on ne considère que les termes de la somme correspondant aux mots de code x' les plus proches de x au lieu de tous les mots de codes x' possibles.

La figure 39 représente des courbes de taux d'erreur trame sur canal gaussien du turbocode pour différentes configurations d'entrelacement, pour différents rendements de codage *R,* avec un canal gaussien, une modulation BPSK, une longueur du message numérique d'entrée égale à *K* = 1504, et 16 itérations de décodage BCJR.

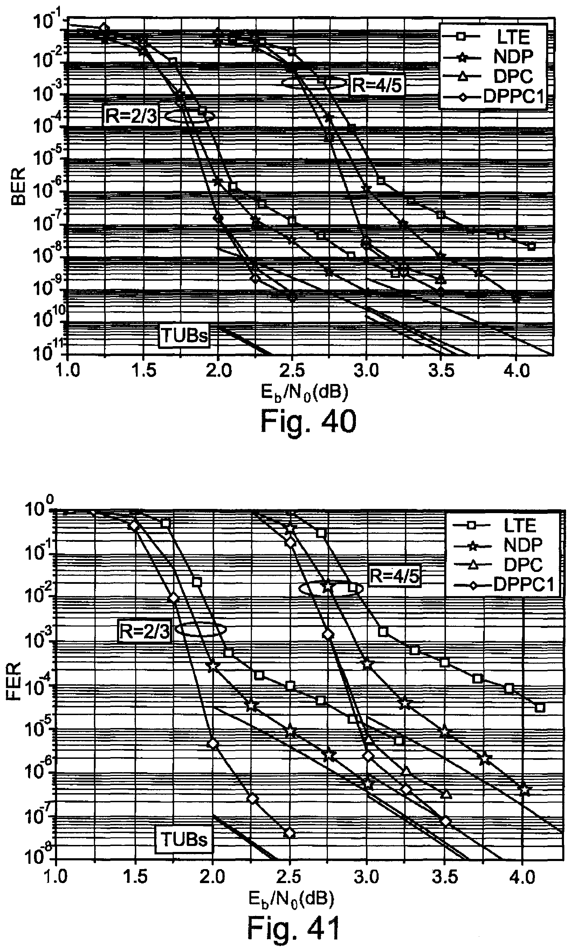

La figure 40 représente des courbes de taux d'erreur binaire du turbocode pour différentes configurations d'entrelacement, pour différents rendements de codage *R,* avec un canal gaussien, une modulation BPSK, une longueur du message numérique d'entrée égale à *K* = 6144, et 16 itérations de décodage BCJR.

La figure 41 représente des courbes de taux d'erreur trame sur canal gaussien du turbocode pour différentes configurations d'entrelacement, pour différents rendements de codage *R,* avec un canal gaussien, une modulation BPSK, une longueur du message numérique d'entrée égale à *K* = 6144, et 16 itérations de décodage BCJR.

L'invention n'est pas limitée aux exemples qui viennent d'être décrits.

Parmi les applications possibles de l'invention, se trouvent les systèmes de transmission relevant de la future norme de téléphonie mobile de cinquième génération, dit « 5G ». Ces systèmes devront en effet répondre à de nouveaux cas d'usages nécessitant des connections très fiables et/ou très efficaces du point de vue de l'utilisation spectrale. Les modes de transmission correspondants devront faire appel à des codes correcteurs d'erreurs plus performants à faible taux d'erreurs que les codes actuels des normes 3G et 4G.

L'invention peut être utilisée dans des applications pour lesquelles la sécurité prime, dites « *mission-critical communications* » en anglais, telles que la coordination de véhicules, le pilotage de réseaux électriques, ou dans des applications de diffusion (« *broadcasting* » en anglais), où la voie de retour ne peut pas être utilisée pour la retransmission des données, ou dans toutes les applications nécessitant une faible latence et pour lesquelles l'utilisation de la voie de retour doit être évitée autant que faire se peut, par exemple dans les applications de jeux interactifs en ligne.

L'expression « *comportant un* » doit être comprise comme signifiant « *comportant au moins un* », sauf si le contraire est spécifié.

**Revendications**

1. Procédé de codage d'un message numérique d'entrée, portant K symboles d'information, mettant en œuvre un turbo-encodeur formant un turbocode, le turbo-encodeur comportant un entrelaceur (20) et des premier et deuxième encodeurs (C1, C2) à encodage selon au moins un code élémentaire, et délivrant lesdits symboles d'information et des symboles de redondance,

   **caractérisé en ce que**, un poinçonnage des symboles délivrés par ledit turbo-encodeur étant effectué suivant au moins un motif de poinçonnage périodique de longueur *N,* définissant la période de poinçonnage, ledit entrelaceur répartit les symboles d'information dudit message d'entrée dans *Q* couches du message d'entrée entrelacé en respectant une fonction d'entrelacement définie à partir dudit au moins un motif de poinçonnage, selon la relation :

$$\pi(i) = Pi + S(i \bmod Q) \bmod K = Pi + (T_l + A_l Q) \bmod K$$

   avec :

   - $i$ = 0, ..., $K$ - 1 la position d'un symbole d'information dans ledit message d'entrée entrelacé, dans l'ordre entrelacé, et $\pi(i)$ la position dudit symbole d'information dans ledit message d'entrée, dans l'ordre naturel ;
   - $P$ une valeur entière première avec la longueur $K$ dudit message d'entrée, dite période de l'entrelaceur ;
   - $S(i \bmod Q) = S(l) = T_l + A_l Q$ les paramètres d'ajustement de la fonction d'entrelacement, avec $l$ = 0, ... , $Q$ - 1 le numéro de la couche ;
   - $Q$ degré de désordre inséré dans l'entrelaceur, correspondant au nombre de couches, tel que $Q = qN$, avec $q \geq 1$ un entier, et $Q$ un diviseur de $K$ ;
   - $T_l$ une valeur d'ajustement inter-couches définie à partir dudit au moins un motif de poinçonnage ; et
   - $A_l$ une valeur d'ajustement intra-couche.

2. Procédé de codage selon la revendication 1, **caractérisé en ce que**, ledit poinçonnage mettant en œuvre un poinçonnage des symboles d'information délivrés par ledit turbo-encodeur, la valeur d'ajustement inter-couches $T_l$ fait correspondre les symboles d'information poinçonnés entre leur position dans l'ordre naturel et leur position dans l'ordre entrelacé.

3. Procédé de codage selon l'une quelconque des revendications 1 et 2, **caractérisé en ce que** la valeur d'ajustement inter-couches $T_l$ fait correspondre les positions des symboles d'information non poinçonnés les plus fragiles aux positions des symboles d'information non poinçonnés les moins fragiles, le degré de fragilité des positions étant déterminé en comparant les spectres des distances des codes élémentaires obtenus en poinçonnant un par un chacun des symboles d'information non poinçonnés, la position la moins fragile correspondant au spectre ayant la distance minimale de Hamming la plus grande et la multiplicité la plus faible, et la position la plus fragile correspondant au spectre ayant la distance minimale de Hamming la plus faible et la multiplicité la plus grande,

la multiplicité correspondant au nombre de mots d'un code élémentaire à une distance d.

4. Procédé de codage selon l'une quelconque des revendications 1 à 3, **caractérisé en ce que** la valeur de l'ajustement inter-couches $T_l$ fait correspondre les positions des symboles d'information poinçonnés les plus fragiles aux positions des symboles d'information poinçonnés les moins fragiles, le degré de fragilité des positions étant déterminé en fonction du nombre de symboles de redondance poinçonnés, les positions les moins fragiles étant celles pour lesquelles aucun symbole de redondance n'est poinçonné et les plus fragiles celles pour lesquelles tous les symboles de redondance sont poinçonnés.

5. Procédé de codage selon l'une quelconque des revendications 3 et 4, **caractérisé en ce que** les degrés de fragilité des positions ayant le même nombre de symboles de redondance poinçonnés sont déterminés sur la base au moins d'une comparaison des spectres des distances des codes élémentaires obtenus en poinçonnant un par un chacun des symboles de redondance non poinçonnés, la position la moins fragile correspondant au spectre ayant la distance minimale de Hamming la plus grande et la multiplicité la plus faible, et la position la plus fragile correspondant au spectre ayant la distance minimale de Hamming la plus faible et la multiplicité la plus grande.

6. Procédé de codage selon l'une quelconque des revendications 1 à 5, **caractérisé en ce que** les paramètres d'ajustement de la fonction d'entrelacement sont déterminés en fonction de valeurs prédéfinies de la distance cumulée spatiale minimale $S_{min}$ et de la longueur du cycle minimal de corrélation $G_{min}$ de l'entrelaceur, pour au moins une période P de l'entrelaceur,

la longueur du cycle minimal de corrélation $G_{min}$ de l'entrelaceur correspondant à la longueur du cycle de corrélation le plus court du graphe de corrélation entre le message d'entrée, dans l'ordre naturel, et le message d'entrée entrelacé, dans l'ordre entrelacé.

7. Procédé de codage selon la revendication 6, **caractérisé en ce que** la valeur prédéfinie de la distance cumulée spatiale minimale $S_{min}$ de l'entrelaceur est inférieure ou égale au plus grand entier inférieur à la racine carrée du double de la longueur $K$ du message numérique d'entrée, et la valeur prédéfinie de la longueur du cycle minimal de corrélation $G_{min}$ de l'entrelaceur est inférieure ou égale à la borne théorique de Moore $\lfloor 2\log_3(K) \rfloor$.

8. Procédé de codage selon l'une quelconque des revendications 1 à 7, **caractérisé en ce que** la période $P$ de l'entrelaceur est choisie pour garantir une valeur de distance cumulée spatiale minimale $S_{min}$ de l'entrelaceur supérieure ou égale à la distance cumulée spatiale minimale d'un entrelaceur régulier respectant une fonction d'entrelacement $\Pi(i) = Pi\ mod\ K.$

9. Procédé selon l'une quelconque des revendications précédentes, dans lequel les deux codes élémentaires des premier et deuxième encodeurs (C1, C2) du turbo-encodeur sont identiques.

10. Procédé selon l'une quelconque des revendications précédentes, dans lequel les codes élémentaires des premier et deuxième encodeurs (C1, C2) du turbo-encodeur sont circulaires.

11. Procédé selon l'une quelconque des revendications précédentes, dans lequel la période de poinçonnage est un diviseur de la longueur du message numérique d'entrée.

12. Programme d'ordinateur comportant des instructions pour la mise en œuvre d'un procédé de codage selon l'une quelconque des revendications 1 à 11 lorsque ce programme est exécuté par un processeur.

13. Turbo-encodeur formant un turbocode destiné à coder un message numérique d'entrée portant K symboles d'information,

le turbo-encodeur comportant un entrelaceur (20) et des premier et deuxième encodeurs (C1, C2) à encodage selon au moins un code élémentaire, et délivrant lesdits symboles d'information et des symboles de redondance,

**caractérisé en ce qu'**un poinçonnage des symboles délivrés par ledit turbo-encodeur étant effectué suivant au moins un motif de poinçonnage périodique de longueur N, définissant la période de poinçonnage, ledit entrelaceur répartit les symboles d'information dudit message d'entrée dans $Q$ couches du message d'entrée entrelacé en respectant une fonction d'entrelacement définie à partir dudit au moins un motif de poinçonnage, selon la relation :

$$\pi(i) = Pi + S(i \bmod Q) \bmod K = Pi + (T_l + A_l Q) \bmod K$$

avec :

- $i$ = 0, ...,$K$ - 1 la position d'un symbole d'information dans ledit message d'entrée entrelacé, dans l'ordre entrelacé, et $\pi(i)$ la position dudit symbole d'information dans ledit message d'entrée, dans l'ordre naturel ;
- $P$ une valeur entière première avec la longueur $K$ dudit message d'entrée, dite période de l'entrelaceur ;
- $S(i \bmod Q) = S(l) = T_l + A_l Q$ les paramètres d'ajustement de la fonction d'entrelacement, avec $l$ = 0, ... , $Q$ - 1 le numéro de la couche ;
- $Q$ degré de désordre inséré dans l'entrelaceur, correspondant au nombre de couches, tel que $Q = qN$, avec $q \geq 1$ un entier, et $Q$ un diviseur de $K$ ;
- $T_l$ une valeur d'ajustement inter-couches définie à partir dudit au moins un motif de poinçonnage ; et
- $A_l$ une valeur d'ajustement intra-couche.

**Patentansprüche**

1. Verfahren zur Codierung einer digitalen Eingangsnachricht, die K Informationssymbole trägt, das einen Turbo-Codierer implementiert, der einen Turbocode bildet, wobei der Turbo-Codierer einen Verschachteler (20) und einen ersten und zweiten Codierer (C1, C2) mit Codierung gemäß wenigstens einem Elementarcode aufweist und die Informationssymbole und Redundanzsymbole liefert, **dadurch gekennzeichnet, dass**, wobei eine Punktierung der Symbole, die vom Turbo-Codierer geliefert werden, wenigstens einem periodischen Punktierungsmotiv einer Länge N zufolge durchgeführt wird, das die Punktierungsperiode definiert, der Verschachteler die Informationssymbole der Eingangsnachricht in Q Schichten der verschachtelten Eingangsnachricht unter Einhaltung einer Verschachtelungsfunktion, die ausgehend von dem wenigstens einen Punktierungsmotiv definiert ist, gemäß dem folgenden Verhältnis verteilt:

$$\Pi(i) = Pi + S(i \bmod Q) \bmod K = Pi + (T_l + A_l Q) \bmod K$$

wobei:

- $i$ = 0, ..., $K$ - 1 die Position eines Informationssymbols in der verschachtelten Eingangsnachricht in der verschachtelten Reihenfolge und $\Pi(i)$ die Position des Informationssymbols in der Eingangsnachricht in der natürlichen Reihenfolge ist;
- $P$ ein erster ganzzahliger Wert mit der Länge K der Eingangsnachricht ist, Periode des Verschachtelers genannt;
- $S(i \bmod Q) = S(l) = T_l + A_{l}Q$ die Einstellparameter der Verschachtelungsfunktion sind, wobei $l$ = 0,..., $Q$ - 1 die Zahl der Schicht ist;
- $Q$ der Unordnungsgrad ist, der in den Verschachteler eingefügt wird, der der Anzahl von Schichten entspricht, wie beispielsweise $Q = qN$, wobei $q \geq 1$ eine Ganzzahl und $Q$ ein Teiler von $K$ ist;
- $T_l$ ein Wert einer Einstellung zwischen Schichten ist, der ausgehend von dem mindestens einen Punktierungsmotiv definiert ist; und
- $A_l$ ein Wert einer Einstellung innerhalb einer Schicht ist.

2. Codierungsverfahren nach Anspruch 1, **dadurch gekennzeichnet, dass**, wobei die Punktierung eine Punktierung der Informationssymbole implementiert, die vom Turbo-Codierer geliefert werden, der Wert einer Einstellung zwischen Schichten $T_l$ die punktierten Informationssymbole zwischen ihrer Position in der natürlichen Reihenfolge und ihrer Position in der verschachtelten Reihenfolge in Entsprechung bringt.

3. Codierungsverfahren nach einem der Ansprüche 1 und 2, **dadurch gekennzeichnet, dass** der Wert einer Einstellung zwischen Schichten $T_l$ die anfälligsten Positionen der unpunktierten Informationssymbole mit den am wenigsten anfälligen Positionen der unpunktierten Informationssymbole in Entsprechung bringt, wobei der Anfälligkeitsgrad der Positionen durch Vergleichen der Spektren der Abstände der Elementarcodes bestimmt werden, die durch Punktierung jedes der unpunktierten Informationssymbole eins nach dem anderen erhalten werden, wobei die am wenigsten anfällige Position dem Spektrum mit dem größten minimalen Hamming-Abstand und der geringsten Multiplizität entspricht und die anfälligste Position dem Spektrum mit dem geringsten minimalen Hamming-Abstand und der größten Multiplizität entspricht, wobei die Multiplizität der Anzahl von Wörtern eines Elementarcodes mit einem Abstand d entspricht.

4. Codierungsverfahren nach einem der Ansprüche 1 bis 3, **dadurch gekennzeichnet, dass** der Wert der Einstellung zwischen Schichten $T_l$ die anfälligsten Positionen der punktierten Informationssymbole mit den am wenigsten anfälligen Positionen der punktierten Informationssymbole in Entsprechung bringt, wobei der Anfälligkeitsgrad der Positionen in Abhängigkeit von der Anzahl von punktierten Redundanzsymbolen bestimmt wird, wobei die am wenigsten anfälligen Positionen diejenigen sind, für welche kein Redundanzsymbol punktiert wird, und die anfälligsten diejenigen sind, für welche alle Redundanzsymbole punktiert werden.

5. Codierungsverfahren nach einem der Ansprüche 3 und 4, **dadurch gekennzeichnet, dass** die Anfälligkeitsgrade der Positionen mit derselben Anzahl von punktierten Redundanzsymbolen auf der Grundlage wenigstens eines Vergleichs der Spektren der Abstände der Elementarcodes bestimmt werden, die durch Punktierung jedes der unpunktierten Informationssymbole eins nach dem anderen erhalten werden, wobei die am wenigsten anfällige Position dem Spektrum mit dem größten minimalen Hamming-Abstand und der geringsten Multiplizität entspricht und die anfälligste Position dem Spektrum mit dem geringsten minimalen Hamming-Abstand und der größten Multiplizität entspricht.

6. Codierungsverfahren nach einem der Ansprüche 1 bis 5, **dadurch gekennzeichnet, dass** die Einstellparameter der Verschachtelungsfunktion in Abhängigkeit von vorgegebenen Werten des minimalen kumulierten räumlichen Abstands $S_{min}$ und der Länge des minimalen Korrelationszyklus $G_{min}$ des Verschachtelers für wenigstens eine Periode P des Verschachtelers bestimmt werden, wobei die Länge des minimalen Korrelationszyklus $G_{min}$ des Verschachtelers der Länge des kürzesten Korrelationszyklus des Graphen der Korrelation zwischen der Eingangsnachricht in der natürlichen Reihenfolge und der verschachtelten Eingangnachricht in der verschachtelten Reihenfolge entspricht.

7. Codierungsverfahren nach Anspruch 6, **dadurch gekennzeichnet, dass** der vorgegebene Wert des minimalen kumulierten räumlichen Abstands $S_{min}$ des Verschachtelers kleiner als oder gleich der größten Ganzzahl ist, die kleiner als die Quadratwurzel des Zweifachen der Länge $K$ der digitalen Eingangsnachricht ist, und der vorgegebene Wert der Länge des minimalen Korrelationszyklus $G_{min}$ des Verschachtelers kleiner als oder gleich der theoretischen Grenze von Moore $\lfloor 2log_3(K) \rfloor$ ist.

8. Codierungsverfahren nach einem der Ansprüche 1 bis 7, **dadurch gekennzeichnet, dass** die Periode $P$ des Verschachtelers gewählt wird, um einen minimalen kumulierten räumlichen Abstandswert $S_{min}$ des Verschachtelers zu gewährleisten, der größer als oder gleich dem minimalen kumulierten räumlichen Abstand eines regelmäßigen Verschachtelers ist, der eine Verschachtelungsfunktion $\Pi(i) = Pi \bmod K$ einhält.

9. Verfahren nach einem der vorhergehenden Ansprüche, wobei die zwei Elementarcodes des ersten und zweiten Codierers (C1, C2) des Turbo-Codierers identisch sind.

10. Verfahren nach einem der vorhergehenden Ansprüche, wobei die Elementarcodes des ersten und zweiten Codierers (C1, C2) des Turbo-Codierers kreisförmig sind.

11. Verfahren nach einem der vorhergehenden Ansprüche, wobei die Punktierungsperiode ein Teiler der Länge der digitalen Eingangsnachricht ist.

12. Computerprogramm aufweisend Anweisungen für die Durchführung eines Codierungsverfahrens nach einem der Ansprüche 1 bis 11, wenn dieses Programm von einem Prozessor ausgeführt wird.

13. Turbo-Codierer, der einen Turbocode bildet, der dazu bestimmt ist, eine digitale Eingangsnachricht zu codieren, die K Informationssymbole trägt, wobei der Turbo-Codierer einen Verschachteler (20) und einen ersten und zweiten Codierer (C1, C2) mit Codierung gemäß wenigstens einem Elementarcode aufweist und die Informationssymbole und Redundanzsymbole liefert,
**dadurch gekennzeichnet, dass**, wobei eine Punktierung der Symbole, die vom Turbo-Codierer geliefert werden, wenigstens einem periodischen Punktierungsmotiv einer Länge N zufolge durchgeführt wird, das die Punktierungsperiode definiert, der Verschachteler die Informationssymbole der Eingangsnachricht in Q Schichten der verschachtelten Eingangsnachricht unter Einhaltung einer Verschachtelungsfunktion, die ausgehend von dem wenigstens einen Punktierungsmotiv definiert ist, gemäß dem folgenden Verhältnis verteilt:

$$\pi(i) = Pi + S (i \bmod Q) \bmod K = Pi + (T_1 + A_1 Q) \bmod K$$

wobei:

- $i = 0, ..., K - 1$ die Position eines Informationssymbols in der verschachtelten Eingangsnachricht in der verschachtelten Reihenfolge und $\pi(i)$ die Position des Informationssymbols in der Eingangsnachricht in der natürlichen Reihenfolge ist;
- $P$ ein erster ganzzahliger Wert mit der Länge K der Eingangsnachricht ist, Periode des Verschachtelers genannt;
- $S$ ($i \bmod Q$) = S(l) = $T_l + A_l Q$ die Einstellparameter der Verschachtelungsfunktion sind, wobei $l = 0,..., Q - 1$ die Zahl der Schicht ist;
- $Q$ der Unordnungsgrad ist, der in den Verschachteler eingefügt wird, der der Anzahl von Schichten entspricht, wie beispielsweise $Q = qN$, wobei $q \geq 1$ eine Ganzzahl und $Q$ ein Teiler von $K$ ist;
- $T_l$ ein Wert einer Einstellung zwischen Schichten ist, der ausgehend von dem mindestens einen Punktierungsmotiv definiert ist; und
- $A_l$ ein Wert einer Einstellung innerhalb einer Schicht ist.

**Claims**

1. Method for encoding an input digital message, bearing K information symbols, using a turbo-encoder forming a turbocode, the turbo-encoder comprising an interleaver (20) and first and second encoders (C1, C2) for encoding according to at least one elementary code, and delivering said information symbols and redundancy symbols, **characterized in that**, with a puncturing of the symbols delivered by said turbo-encoder being performed according to at least one periodic puncturing pattern of a length N, defining the puncturing period, said interleaver distributes the information symbols of said input message into Q layers of the interleaved input message in compliance with an interleaving function defined on the basis of said at least one puncturing pattern, according to the relationship:

$$\pi(i) = Pi + S(i \bmod Q) \bmod K = Pi + (T_1 + A_1 Q) \bmod K$$

with:

- $i=0, ..., K$-1 the position of an information symbol in said interleaved input message, in the interleaved order, and $\pi(i)$ the position of said information symbol in said input message, in the natural order;
- $P$ an integer value co-prime with the length $K$ of said input message, called an interleaver period;
- $S(i \bmod Q)=S(l)=T_l+A_l Q$ the parameters of adjustment of the interleaving function, with $l=0,..., Q$-1 the layer number;
- $Q$ a degree of disorder inserted into the interleaver, corresponding to the number of layers, such that $Q=qN$, with $q \geq 1$ being an integer and $Q$ being a divider of $K$;
- $T_l$ a value of inter-layer adjustment defined on the basis of said at least one puncturing pattern; and
- $A_l$ a value of intra-layer adjustment.

2. Encoding method according to Claim 1, **characterized in that**, said puncturing implementing a puncturing of the information symbols delivered by said turbo-encoder, the value of inter-layer adjustment $T_l$ makes the punctured information symbols correspond between their position in the natural order and their position in the interleaved order.

3. Encoding method according to either one of Claims 1 and 2, **characterized in that** the inter-layer adjustment value $T_l$ makes the positions of the most fragile non-punctured information symbols correspond with the positions of the least fragile non-punctured information symbols, the degree of fragility of the positions being determined by comparing the distance spectra of the elementary codes obtained by puncturing each of the non-punctured information symbols one by one, the least fragile position corresponding to the spectrum having the greatest minimum Hamming distance and the lowest multiplicity, and the most fragile position corresponding to the spectrum having the smallest minimum Hamming distance and the highest multiplicity, the multiplicity corresponding to the number of words of an elementary code at a distance d.

4. Encoding method according to any one of Claims 1 to 3, **characterized in that** the inter-layer adjustment value $T_l$

makes the positions of the most fragile punctured information symbols correspond with the positions of the least fragile punctured information symbols,

the degree of fragility of the positions being determined as a function of the number of punctured redundancy symbols, the least fragile positions being those for which no redundancy symbol is punctured and the most fragile positions being those for which all of the redundancy symbols are punctured.

5. Encoding method according to either one of Claims 3 and 4, **characterized in that** the degrees of fragility of the positions having the same number of punctured redundancy symbols are determined on the basis of at least one comparison of the distance spectra of the elementary codes obtained by puncturing each of the non-punctured redundancy symbols one by one, the least fragile position corresponding to the spectrum having the greatest minimum Hamming distance and the lowest multiplicity, and the most fragile position corresponding to the spectrum having the smallest minimum Hamming distance and the highest multiplicity.

6. Encoding method according to any one of Claims 1 to 5, **characterized in that** the adjustment parameters of the interleaving function are determined as a function of predefined values of the minimum cumulative spatial distance $S_{min}$ and of the length of the minimum correlation cycle $G_{min}$ of the interleaver, for at least one interleaver period P, the length of the minimum correlation cycle $G_{min}$ of the interleaver corresponding to the length of the shortest correlation cycle of the graph of correlation between the input message, in the natural order, and the interleaved input message, in the interleaved order.

7. Encoding method according to Claim 6, **characterized in that** the predefined value of the minimum cumulative spatial distance $S_{min}$ of the interleaver is lower than or equal to the largest integer smaller than the square root of twice the length $K$ of the input digital message, and the predefined value of the length of the minimum correlation cycle $G_{min}$ of the interleaver is lower than or equal to Moore's theoretical limit $\lfloor 2\log_3(K) \rfloor$.

8. Encoding method according to any one of Claims 1 to 7, **characterized in that** the period P of the interleaver is chosen to ensure a minimum cumulative spatial distance value $S_{min}$ of the interleaver higher than or equal to the minimum cumulative spatial distance of a regular interleaver in compliance with an interleaving function $\Pi(i) = Pi \bmod K$.

9. Method according to any one of the preceding claims, wherein the two elementary codes of the first and second encoders (C1, C2) of the turbo-encoder are identical.

10. Method according to any one of the preceding claims, wherein the elementary codes of the first and second encoders (C1, C2) of the turbo-encoder are circular.

11. Method according to any one of the preceding claims, wherein the puncturing period is a divider of the length of the input digital message.

12. Computer program comprising instructions for the implementation of an encoding method according to any one of Claims 1 to 11 when this program is executed by a processor.

13. Turbo-encoder forming a turbocode for encoding an input digital message bearing K information symbols, the turbo-encoder comprising an interleaver (20) and first and second encoders (C1, C2) for encoding according to at least one elementary code, and delivering said information symbols and redundancy symbols, **characterized in that**, with a puncturing of the symbols delivered by said turbo-encoder being performed according to at least one periodic puncturing pattern of a length N, defining the puncturing period, said interleaver distributes the information symbols of said input message into Q layers of the interleaved input message in compliance with an interleaving function defined on the basis of said at least one puncturing pattern, according to the relationship:

$$\Pi(i) = Pi + S(i \bmod Q) \bmod K = Pi + (T_l + A_l Q) \bmod K$$

with:

- $i = 0, \dots, K-1$ the position of an information symbol in said interleaved input message, in the interleaved order, and $\Pi(i)$ the position of said information symbol in said input message, in the natural order;
- P an integer value co-prime with the length K of said input message, called an interleaver period;
- $S(i \bmod Q) = S(l) = T_l + A_l Q$ the parameters of adjustment of the interleaving function, with $l = 0, \dots, Q-1$ the layer number;
- $Q$ a degree of disorder inserted into the interleaver, corresponding to the number of layers, such that $Q=qN$, with q≥1 being an integer and $Q$ being a divider of $K$;
- $T_l$ a value of inter-layer adjustment defined on the basis of said at least one puncturing pattern; and
- $A_l$ a value of intra-layer adjustment.

## Fig. 1A

## Fig. 2

## Fig. 3
### ETAT de L'ART

## Fig. 4
### ETAT de L'ART

```
┌─────────────────┐
│   Sèlection du  │
│     motif de    │
│   poinçonnage   │───╮11
└─────────────────┘
         │
         ▼
┌─────────────────┐
│   Dètermination │
│   du degrè de   │
│   fragilité des │
│    positions    │───╮12
└─────────────────┘
         │
         ▼
┌─────────────────┐
│    Règles de    │
│   connexion de  │
│   l'entrelaceur │───╮13
└─────────────────┘
         │
         ▼
┌─────────────────┐
│    Paramètres   │
│   d'ajustement  │
│ de l'entrelaceur│───╮14
└─────────────────┘
         │
         ▼
┌─────────────────┐
│    Sèlection    │
│      d'un       │
│   entrelaceur   │───╮15
└─────────────────┘
```

# Fig. 5

Fig. 6

Fig. 7

|  | 0 | 1 | 2 | 3 | 4 | 5 | 6 | 7 |
|---|---|---|---|---|---|---|---|---|

Motif de poinçonnage
des symboles d'information

| 0 | 1 | 0 | 1 | 0 | 1 | 1 | 1 |
|---|---|---|---|---|---|---|---|

|  | 0 | 1 | 2 | 3 | 4 | 5 | 6 | 7 |
|---|---|---|---|---|---|---|---|---|

| 0 | 1 | 0 | 1 | 0 | 1 | 1 | 1 |
|---|---|---|---|---|---|---|---|

Connexions admissibles
pour les symboles
d'information poinçonnés

| 0 | 1 | 0 | 1 | 0 | 1 | 1 | 1 |
|---|---|---|---|---|---|---|---|

|  | 0 | 1 | 2 | 3 | 4 | 5 | 6 | 7 |
|---|---|---|---|---|---|---|---|---|

| 0 | 1 | 0 | 1 | 0 | 1 | 1 | 1 |
|---|---|---|---|---|---|---|---|

Connexions admissibles
pour les symboles
d'information non
poinçonnés

| 0 | 1 | 0 | 1 | 0 | 1 | 1 | 1 |
|---|---|---|---|---|---|---|---|

## Fig. 8
### ETAT de L'ART

Motif de poinçonnage
des symboles d'information

| 0 | 1 | 0 | 1 | 1 | 1 | 1 | 1 |
|---|---|---|---|---|---|---|---|
|  | 2 |  | 5 | 6 | 4 | 1 | 3 |

Classement
par ordre de
fragilité croissante

## Fig. 9

Motifs de poinçonnage     0   1   2   3   4   5   6   7
Symboles d'information    | 1 | 0 | 1 | 0 | 0 | 0 | 0 | 0 |

Redondances 1            | 1 | 1 | 1 | 0 | 1 | 1 | 1 | 1 |

Redondances 2            | 0 | 1 | 0 | 1 | 1 | 0 | 1 | 0 |

## Fig. 10A

Motifs de poinçonnage     0   1   2   3   4   5   6   7
Symboles d'information    | 1 | 0 | 1 | 0 | 0 | 0 | 0 | 0 |

Redondances 1            | 1 | 1 | 1 | 0 | 1 | 1 | 1 | 1 |

Redondances 2            | 0 | 1 | 0 | 1 | 1 | 0 | 1 | 0 |

Classement positions "pointillès":      2           1       3

Classement positions "pleins":              2       1           3

Classement final:               2       5   1   4   3   6

## Fig. 10B

Motif de poinçonnage
des symboles d'information

Classement par ordre de
fragilité croissante

Masque de connexion 1:
connexion de la position
la moins fragile à la
position la plus fragile

Masque de connexion 2:
connexion des deux
positions les moins
fragiles aux deux
positions les plus fragiles

Masque de connexion 3:
connexion croisée
complète

## Fig. 11

Motifs de poinçonnage

Symboles d'information

Classement par ordre de fragilité coissante

Masque de connexion 1:
connexion de la position
la moins fragile à la
position la plus fragile

Redondances 1

Redondances 2

Masque de connexion 2:
connexion des deux
positions les moins
fragiles aux deux
positions les plus fragiles

Redondances 1

Redondances 2

Redondances 1

Masque de connexion 3:
connexion croisée complète

Redondances 2

## Fig. 12

Fig. 13A

Fig. 13B

Fig. 14

Fig. 15

Fig. 16

$(P \times l + T_l) \bmod Q$    0   1   2   3   4   5   6   7

Masque
de
connexion

$l$   0   1   2   3   4   5   6   7

## Fig. 17

Motif de poinçonnage
des symboles d'information

| 0 | 1 | 2 | 3 | 4 | 5 | 6 | 7 |
|---|---|---|---|---|---|---|---|
| 0 | 1 | 1 | 1 | 1 | 1 | 1 | 0 |

Connexions admissibles
pour les symboles
d'information poinçonnés

| 0 | 1 | 2 | 3 | 4 | 5 | 6 | 7 |
|---|---|---|---|---|---|---|---|
| 0 | 1 | 1 | 1 | 1 | 1 | 1 | 0 |

| 0 | 1 | 1 | 1 | 1 | 1 | 1 | 0 |
|---|---|---|---|---|---|---|---|

## Fig. 18

Masque
de
connexion

| 0 | 1 | 2 | 3 | 4 | 5 | 6 | 7 |
|---|---|---|---|---|---|---|---|
| 0 | 1 | 1 | 1 | 1 | 1 | 1 | 0 |

| 0 | 1 | 1 | 1 | 1 | 1 | 1 | 0 |
|---|---|---|---|---|---|---|---|

Position
la moins
fragile

Position
la plus
fragile

## Fig. 19

Motif de poinçonnage
des symboles d'information

| 0 | 1 | 2 | 3 | 4 | 5 | 6 | 7 |
|---|---|---|---|---|---|---|---|
| 0 | 1 | 1 | 1 | 1 | 1 | 1 | 0 |

1 2 4 6 3 5  Classement
par ordre de
fragilité croissante

Masque
de connexion

| 0 | 1 | 2 | 3 | 4 | 5 | 6 | 7 |
|---|---|---|---|---|---|---|---|
| 0 | 1 | 1 | 1 | 1 | 1 | 1 | 0 |

| 0 | 1 | 1 | 1 | 1 | 1 | 1 | 0 |
|---|---|---|---|---|---|---|---|

## Fig. 20

Masque de connexion pour
les symboles
d'information poinçonnés

| 0 | 1 | 2 | 3 | 4 | 5 | 6 | 7 |
|---|---|---|---|---|---|---|---|
| 0 | 1 | 1 | 1 | 1 | 1 | 1 | 0 |

| 0 | 1 | 1 | 1 | 1 | 1 | 1 | 0 |
|---|---|---|---|---|---|---|---|

## Fig. 21

Fig. 22

Fig. 23

Fig. 24

**Fig. 25**

**Fig. 26**

Fig. 27

Fig. 28

|   | 0 | 1 | 2 | 3 | 4 | 5 | 6 | 7 | 8 | 9 | 10 | 11 | 12 | 13 | 14 | 15 |

Masque de connexion

|   | 0 | 1 | 1 | 1 | 1 | 1 | 1 | 1 | 1 | 1 | 1 | 1 | 1 | 1 | 0 | 1 |

|   | 0 | 1 | 1 | 1 | 1 | 1 | 1 | 1 | 1 | 1 | 1 | 1 | 1 | 1 | 0 | 1 |

Position la moins fragile

Position la plus fragile

## Fig. 29

Motif de poinçonnage des symboles d'information non poinçonnés

|   | 0 | 1 | 2 | 3 | 4 | 5 | 6 | 7 | 8 | 9 | 10 | 11 | 12 | 13 | 14 | 15 |

|   | 0 | 1 | 1 | 1 | 1 | 1 | 1 | 1 | 1 | 1 | 1 | 1 | 1 | 1 | 0 | 1 |

Classement par ordre de fragilité croissante

1    4   12   9    6    3   13   11   5   14   7    8    2         10

|   | 0 | 1 | 2 | 3 | 4 | 5 | 6 | 7 | 8 | 9 | 10 | 11 | 12 | 13 | 14 | 15 |

Masque de connexion

## Fig. 30

|   | 0 | 1 | 2 | 3 | 4 | 5 | 6 | 7 | 8 | 9 | 10 | 11 | 12 | 13 | 14 | 15 |

Masque de connexion pour les symboles d'information poinçonnés

|   | 0 | 1 | 1 | 1 | 1 | 1 | 1 | 1 | 1 | 1 | 1 | 1 | 1 | 1 | 0 | 1 |

|   | 0 | 1 | 1 | 1 | 1 | 1 | 1 | 1 | 1 | 1 | 1 | 1 | 1 | 1 | 0 | 1 |

## Fig. 31

Fig. 32

Fig. 33

Fig. 34

Motif de poinçonnage
des symboles d'information

Groupes de connexions
Admissibles

Fig. 35

|  | 0 | 1 | 2 | 3 | 4 | 5 | 6 | 7 |
|---|---|---|---|---|---|---|---|---|
|  | 1 | 0 | 1 | 0 | 0 | 0 | 0 | 0 |

Masque de connexion
des symboles d'information
non poinçonnés

|  | 1 | 0 | 1 | 0 | 0 | 0 | 0 | 0 |
|---|---|---|---|---|---|---|---|---|

# Fig. 36

| Motifs de poinçonnage | 0 | 1 | 2 | 3 | 4 | 5 | 6 | 7 |
|---|---|---|---|---|---|---|---|---|
| Symboles d'information | 1 | 0 | 1 | 0 | 0 | 0 | 0 | 0 |
| Redondances 1 | 1 | 1 | 1 | 0 | 1 | 1 | 1 | 1 |
| Redondances 2 | 0 | 1 | 0 | 1 | 1 | 0 | 1 | 0 |

# Fig. 37

Fig. 38

Fig. 39

Fig. 40

Fig. 41

Fig. 1B

Fig. 1C

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20080256424 A
- WO 2000035103 A
- WO 2000010257 A
- WO 2006069392 A
- US 20070288834 A

- WO 2007047472 A
- WO 2008057041 A
- WO 2010148763 A
- US 2007028834 A
- US 20080086674 A

**Littérature non-brevet citée dans la description**

- Turbocodes convolutifs. Codes et turbocodes. Springer, 2007
- **O. ACIKEL ; W. RYAN.** Punctured turbo-codes for BPSK/QPSK channels. *IEEE Trans. Commun.,* Septembre 1999, vol. 47 (9), 1315-1323
- **F. MO et al.** Analysis of puncturing pattern for high rate turbo codes. *Proc. IEEE Conférence on Military Communications (MIL-COM 1999),* Septembre 1999, vol. 1, 547-550
- **S. CROZIER et al.** On designing turbo-codes with data puncturing. *Canadian Workshop of Information Theory (CWIT 2005),* Juin 2005
- Rate-compatible turbo codes designed with puncture-constrained DRP interleavers. *IEEE Global Telecommun. Conf.,* Décembre 2011, 1-5
- On the error-rate performance of 4-state turbo codes with puncture-constrained DRP interleavers. *IEEE International Conférence on Communications (ICC),* Juin 2012, 2601-2605
- **KIM HYUNG-KYUNG.** Interleaver Design for punctured turbo codes based on RSC code structure. *Proc. 2013 International Conférence on ICT Convergence,* 393-397
- **I. CHATZIGEORGIOU.** Punctured binary turbo codes with optimized performance. *Proc. 62nd Vehicular Technology Conférence,* 1965-1969
- **C. BERROU et al.** Designing good permutations for turbocodes: towards a single model. *IEEE International Conférence on Communications,* 2004, vol. 1, 341-345
- **S. CROZIER ; P. GUINAND.** High-performance low-memory interleaver banks for turbo-codes. *IEEE 54th Vehicular Technology Conference,* Octobre 2001, vol. 4, 2394-2398
- **J. SUN ; O. TAKESHITA.** Interleavers for turbo codes using permutation polynomials over integer rings. *IEEE Trans. Inf. Theory,* Janvier 2005, vol. 51 (1), 101-119

- **GARZÓN BOHÓRQUEZ et al.** On the equivalence of interleavers for turbo codes. *IEEE Wireless Communication Letters,* Février 2015, vol. 4 (1), 58-61
- **C. BERROU et al.** Computing the minimum distance of linear codes by the error impulse method. *IEEE Global Telecommun. Conf.,* Novembre 2002, vol. 2, 1017-1020
- **R. GARELLO ; A. VILA-CASADO.** The all-zero iterative decoding algorithm for turbo code minimum distance computation. *IEEE International Conférence on Communications (ICC),* Juin 2004, vol. 1, 361-364
- **S. CROZIER et al.** Estimating the minimum distance of turbo-codes using double and triple impulse methods. *IEEE Commun. Lett.,* 2005, vol. 9 (7), 631-633
- Estimating the minimum distance of large-block turbo codes using iterative multiple-impulse methods. *4th Int. Symposium on Turbo Codes and Related Topics (ISTC),* 2006, 1-6
- Estimating the minimum distance oflarge block turbo codes using the event impulse method. *Int. Symposium on Turbo Codes and Iterative Information Processing (ISTC),* Septembre 2010, 439-443
- **M. CEDERVALL ; R. JOHANNESSON.** A fast algorithm for computing distance spectrum of convolutional codes. *IEEE Trans. Inf. Theory,* Novembre 1989, vol. 35 (6), 1146-1159
- **S. BENEDETTO ; G. MONTORSI.** Unveiling turbo codes: some results on parallel concatenated coding schemes. *IEEE Trans. Inf. Theory,* 1996, vol. 42 (2), 409-428
- Minimal regular graphs with given girth. **N. BIGGS.** Algebraic graph theory. Cambridge University Press, 1974, 180-190
- **E. BOUTILLON ; D. GNAEDIG.** Maximum spread of D-dimensional multiple turbo codes. *IEEE Trans. Commun.,* 2005, vol. 53 (8), 1237-1242

- **Y. SAOUTER.** Selection procedure of turbocode parameters by combinatorial optimization. *Int. Symposium on Turbo Codes and Iterative Information Processing (ISTC),* Septembre 2010, 156-160
- **H. MA ; J. K. WOLF.** On tail-biting convolutional codes. *IEEE Trans. Commun.,* 1986, vol. 34 (2), 104-111
- **C. WEISS et al.** Turbo decoding with tail-biting trellises. *URSI Intern. Symp. on Signais, Systems, and Electronics (ISSSE),* Octobre 1998, 343-348
- Code construction and decoding of parallel concatenated tail-biting codes. *IEEE Trans. Inform. Theory,* Janvier 2001, vol. 47, 366-386